(19) **Europäisches Patentamt** **European Patent Office** **Office européen des brevets**

(11) **EP 4 454 443 B1**

(12) **FASCICULE DE BREVET EUROPEEN**

(45) Date de publication et mention de la délivrance du brevet:
**04.02.2026 Bulletin 2026/06**

(21) Numéro de dépôt: **22838881.5**

(22) Date de dépôt: **22.12.2022**

(51) Classification Internationale des Brevets (IPC):
**H10N 70/00** (2023.01) **H10N 70/20** (2023.01)
**H10B 63/00** (2023.01) **H10B 63/10** (2023.01)

(52) Classification Coopérative des Brevets (CPC):
**H10N 70/24; H10B 63/24; H10B 63/80; H10B 63/845; H10N 70/063; H10N 70/823; H10N 70/8833**

(86) Numéro de dépôt international:
**PCT/EP2022/087644**

(87) Numéro de publication internationale:
**WO 2023/118527 (29.06.2023 Gazette 2023/26)**

(54) **ENSEMBLE COMPRENANT AU MOINS DEUX MÉMOIRES RÉSISTIVES NON-VOLATILES ET DEUX SÉLECTEURS, MATRICE ET PROCÉDÉ DE FABRICATION ASSOCIÉS**

**ANORDNUNG MIT MINDESTENS ZWEI NICHTFLÜCHTIGEN RESISTIVEN SPEICHERN UND ZWEI SELEKTOREN, MATRIX UND ZUGEHÖRIGES HERSTELLUNGSVERFAHREN**

**ASSEMBLY COMPRISING AT LEAST TWO NON-VOLATILE RESISTIVE MEMORIES AND TWO SELECTORS, MATRIX AND ASSOCIATED MANUFACTURING METHOD**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **23.12.2021 FR 2114409**

(43) Date de publication de la demande:
**30.10.2024 Bulletin 2024/44**

(73) Titulaires:
• **Commissariat à l'Energie Atomique et aux Energies Alternatives**
**75015 Paris (FR)**
• **Weebit Nano Ltd**
**4523001 Hod-Hasharon (IL)**

(72) Inventeurs:
• **DORY, Jean-Baptiste**
**38054 Grenoble Cedex 09 (FR)**
• **MOLAS, Gabriel**
**38054 Grenoble Cedex 09 (FR)**
• **NODIN, Jean-François**
**38054 Grenoble Cedex 09 (FR)**
• **VERDY, Anthonin**
**38040 Grenoble Cedex 09 (FR)**

(74) Mandataire: **Cabinet Camus Lebkiri**
**25 rue de Maubeuge**
**75009 Paris (FR)**

(56) Documents cités:
**FR-A1- 3 100 368      US-A1- 2014 175 371**
**US-A1- 2018 047 787**

## Description

### DOMAINE TECHNIQUE DE L'INVENTION

Le domaine technique de l'invention est celui des mémoires résistives non-volatiles. Il concerne également la fabrication de telles mémoires.

### ARRIÈRE-PLAN TECHNOLOGIQUE DE L'INVENTION

L'invention s'insère dans le développement de matrices de mémoires dites « crossbar » en anglais, dans lesquelles une pluralité de points mémoire sont chacun situés au croisement entre une ligne conductrice et une colonne conductrice. Chaque point mémoire est alors adressé, par exemple par l'application d'une tension entre la ligne conductrice et la colonne conductrice auxquelles il est connecté.

L'invention concerne plus particulièrement des points mémoire comprenant une mémoire résistive, c'est à dire une mémoire dans laquelle l'information est stockée sous la forme d'une valeur de résistance électrique. Une mémoire résistive peut être de différents types, selon les phénomènes mis en œuvre pour écrire, stocker et lire l'information.

Les mémoires résistives sont typiquement réalisées dans des couches situées au-dessus d'un substrat (par exemple un substrat en Silicium) sur lequel est réalisée la matrice. On parle alors de composants appartenant à « l'unité de fabrication finale » c'est à dire fabriqués lors des étapes finales de fabrication ou encore BEOL pour « Back-End-Of-Line » en anglais, contrairement aux composants appartenant à « l'unité de fabrication initiale » ou FEOL pour « Front-End-Of-Line » (FEOL) en anglais. Les composants appartement au BEOL sont par exemple intégrés entre les niveaux métalliques d'interconnexion. Les composants FEOL sont fabriqués à la surface du substrat (diodes et transistors CMOS par exemple).

Par exemple, une mémoire dite « à changement de phase » ou PCRAM pour « Phase Change Random Access Memory » en anglais met en œuvre le fort contraste de propriétés électroniques entre une phase amorphe et une phase cristalline d'un matériau.

Une mémoire dite « à pont conducteur » ou CBRAM pour « Conductive Bridge RAM » en anglais, met en œuvre la formation/dissolution d'un filament conducteur dans un électrolyte solide suite à une diffusion d'ions provenant d'une électrode active.

Une mémoire dite « à claquage réversible d'oxyde » ou OxRAM pour « Oxide RAM » en anglais, met en œuvre le claquage réversible d'un matériau diélectrique en fonction d'une tension électrique appliquée à ce matériau.

Une mémoire dite magnétique ou MRAM pour « Magnetic RAM » en anglais, met en œuvre l'aimantation relative entre une couche magnétique de référence et une couche magnétique programmable.

L'utilisation des mémoires résistives se révèle une solution prometteuse pour augmenter la densité des matrices de mémoires. Elles s'insèrent également dans le développement de nouvelles applications telles que le calcul dit « neuromorphique » ou le développement d'une nouvelle classe de mémoires appelée « Storage Class Memory » en anglais. Cependant, les mémoires résistives peuvent présenter différents inconvénients.

Dans une matrice de points mémoire, une pluralité de mémoires résistives sont connectées à une même ligne ou une même colonne. L'application d'une tension d'adressage aux bornes d'une de ces mémoires (par exemple pour la lire) crée toutefois un courant de fuite non-négligeable au niveau des autres mémoires de la même ligne, et de la même colonne. Ce courant de fuite dégrade les capacités de lecture et/ou écriture de l'information au niveau d'une des mémoires.

Afin de résoudre ce problème, il est connu d'ajouter des dispositifs de sélection, appelé « sélecteurs », par exemple relié chacun en série avec chaque mémoire (agencement de type « 1S1R »). L'activation d'un seul sélecteur parmi la pluralité des sélecteurs permet ainsi de sélectionner une seule mémoire, tandis que les autres sélecteurs, bloqués, suppriment ou réduisent les courants de fuites des autres mémoires.

Un type de sélecteur cointégrable dans le « back-end », appelé sélecteur « cointégrable » ou sélecteur « back end » dans la suite, offre une facilité de cointégration avec la mémoire, en série avec celle-ci, ses dimensions pouvant être ajustées aux dimensions de la mémoire résistive. En effet, l'état passant d'un sélecteur « back-end » est suffisamment conducteur et permet de réduire ses dimensions au même niveau que celles de la mémoire avec laquelle il peut être connecté en série. Par ailleurs, un sélecteur « back-end » peut être formé de couches déposées sur ou sous une couche mémoire, et gravées en bloc, en même temps que la couche mémoire. Il existe plusieurs types de sélecteurs back-end.

Un sélecteur ovonique à seuil ou OTS pour « Ovonic Threshold Switching » en anglais, met en œuvre une propriété caractéristique de certains matériaux chalcogénures. Il s'agit du passage, sous l'effet d'un champ électrique, d'un état résistif à un état conducteur métastable. L'état conducteur métastable peut être maintenu aussi longtemps qu'un courant de maintien circule dans le sélecteur OTS. En dehors de quoi, le sélecteur OTS retrouve l'état résistif (état bloqué).

Un sélecteur à pont conducteur instable ou TS pour « Threshold Switch » en anglais, met en œuvre la formation d'un filament métallique métastable par la diffusion, sous l'effet d'un champ électrique, d'une électrode active dans un électrolyte. Lorsque le champ n'est plus appliqué, le filament métallique métastable se dissout.

Un sélecteur à conduction électronique et ionique ou MIEC pour « Mixed ion-electronic conduction » en anglais, met en œuvre la mobilité d'ions métalliques permettant la création d'un courant électrique sous l'effet d'un champ électrique.

Un sélecteur à transition métal-isolant met en œuvre un matériau à forte corrélation électronique nécessitant l'application d'un champ électrique dépassant un champ seuil pour créer un courant électrique, le champ seuil étant fonction de la répulsion coulombienne forçant la localisation des électrons libres dudit matériau.

Enfin, un sélecteur à barrière Schottky ou barrière tunnel met en œuvre une forte non-linéarité dans sa caractéristique courant-tension pour obtenir l'effet de « sélection » souhaité.

Un point mémoire comprenant un sélecteur back-end offre un encombrement réduit et sa fabrication est commode (il peut être gravé en même temps que la partie mémoire résistive du point mémoire). Toutefois, la bonne fonctionnalité de l'ensemble repose notamment sur l'adéquation entre les propriétés électriques du sélecteur et de la mémoire.

Le document FR3100368 A1 divulgue des dispositifs comprenant deux cellules mémoires résistives non volatile de type filamentaire. Le document US2018047787 A1 montre une structure de mémoire de type ReRAM avec une couche de changement de résistance verticale qui est disposée vers le côté le plus proche d'une couche d'électrode et avec une couche de sélection et le document US2014175371 A1 montre un réseau de cellules de mémoire ReRAM qui comprennent respectivement une couche de sélection disposée à chaque point de croisement entre la ligne de bits correspondante et l'élément de mémoire.

Il existe donc un besoin d'un dispositif de mémoire résistive non volatile, à sélecteur, qui soit peu encombrant, commode à fabriquer, et dans lequel les propriétés électriques de la mémoire et du sélecteur peuvent être ajustées, chacune, indépendamment.

## RÉSUMÉ DE L'INVENTION

L'invention concerne un ensemble comprenant au moins deux mémoires résistives non volatiles disposées électriquement en parallèle entre elles et étant chacune électriquement connectées en série à une couche sélectrice formant respectivement au moins deux sélecteurs, chacun dédié à l'une des mémoires selon la revendication indépendante de dispositif 1.

Chaque électrode supérieure est reliée électriquement à une région de conduction de la première couche active, c'est-à-dire de la couche sélectrice de l'ensemble. Par région de conduction ou canal de conduction, on entend une portion de couche active où la résistivité peut varier en fonction d'une tension appliquée ou d'un courant y circulant. Il s'agit en particulier d'une portion où la création/destruction d'une structure conductrice telle qu'un filament de conduction est favorisée.

Les première et deuxième électrodes supérieures étant séparées l'une de l'autre, elles sont donc reliées à des régions de conduction également séparées l'une de l'autre. Ainsi, la première couche active comprend deux régions de conduction distinctes, opérables indépendamment.

Puisque la première couche active est une couche sélectrice, les deux régions de conduction distinctes de la première couche forment ainsi un premier sélecteur et un deuxième sélecteur, distincts, opérables de manière indépendante. Ainsi, chaque sélecteur est relié en série avec un empilement vertical (ou tout au moins oblique), jouant le rôle de mémoire. L'ensemble selon l'invention comprend donc deux ensembles sélecteur/mémoire 1S1R, adressables de manière indépendante et permettant de stocker deux informations distinctes de manière non-volatile. Autrement dit, l'ensemble est de type nSnR où n est au moins égal à deux.

Les dimensions du premier sélecteur dépendent en partie de la surface de la première électrode supérieure s'étendant sur la première couche active. Plus grande est ladite surface, plus grandes sont les dimensions du premier sélecteur, notamment parallèlement au plan horizontal donné. De la même manière, les dimensions du deuxième sélecteur dépendent en partie de la surface (planaire) de la deuxième électrode supérieure s'étendant sur la première couche active. Il est ainsi possible, d'ajuster les dimensions des premier et deuxième sélecteurs de manière indépendante, en ajustant les surfaces planaires des première et deuxième électrodes supérieures s'étendant sur la première couche active.

La première électrode supérieure est également reliée électriquement, par sa surface latérale, à une région de conduction de la deuxième couche active. La région de conduction de la deuxième couche active forme donc une première mémoire. Les dimensions verticales de la première mémoire dépendent en partie de la surface de la première électrode supérieure au contact de la deuxième couche active. Elle est par exemple proportionnelle à une épaisseur de la première électrode supérieure. Plus grande est ladite épaisseur, plus grandes sont les dimensions de la première mémoire. Il est ainsi possible, d'ajuster les dimensions de la première mémoire en ajustant l'épaisseur de la première électrode. L'épaisseur de la première électrode supérieure d'une part, et son agencement (en particulier son étendue) sur la première couche active d'autre part sont ajustables de manière indépendante l'un de l'autre (autrement formulé, l'épaisseur de cette électrode est ajustable indépendamment de des dimensions - latérales - de la zone de conduction du premier sélecteur). Les dimensions du premier sélecteur et de la première mémoire peuvent donc être ajustées de manière indépendante.

Les propriétés électriques de la première mémoire et du premier sélecteur dépendent en partie de leurs dimensions. En effet, le courant traversant la mémoire dépend en partie de l'étendue de la mémoire. Par ailleurs, pour des mémoires de type PCRAM, par exemple, le courant de programmation est proportionnel à la surface de l'électrode contre laquelle elle s'étend. De la même manière, le courant de seuil du sélecteur dépend également en partie de ses dimensions. Et, pour un sélecteur de type OTS, le courant de maintien peut être diminué en réduisant les dimensions du sélecteur, notamment lorsque celles-ci sont inférieure à une dimension critique de l'ordre de 80 nm. Les courants de fuite d'un sélecteur de type MIEC dépendent eux aussi, en partie de la dimension de l'électrode contre laquelle s'étend le sélecteur. Ainsi, les propriétés électriques de la première mémoire, et celles du premier sélecteur peuvent être ajustées de manière indépendante, dans cette architecture particulière, du fait que les surfaces (ou surfaces effectives) de ces éléments peuvent être ajustées indépendamment l'une de l'autre.

Le même raisonnement s'applique à une région de conduction de la troisième couche active, formant une deuxième mémoire. Les propriétés électriques du deuxième sélecteur et de la deuxième mémoire peuvent être ajustées, chacune, de manière indépendante, en ajustant une épaisseur de la deuxième électrode supérieure et sa disposition sur la première couche active.

Comme expliqué en détail en référence aux figures, l'orientation oblique par rapport audit plan, par exemple verticale, d'une partie au moins des deuxième et troisième couches actives, combinée à l'utilisation d'une même première couche sélectrice, horizontale, conduit à une compacité très satisfaisante pour l'ensemble.

De plus, cet agencement géométrique particulier permet, de manière surprenante, d'obtenir des surfaces effectives, (typiquement, des surfaces de superposition, entre électrodes ou contacts électriques) pouvant être inférieure à une surface minimale accessible à première vue pour une finesse de gravure F, c'est à dire inférieure à $F^2$.

Pour chacune des mémoires de l'ensemble, orientée de manière oblique par rapport au plan horizontal, la surface de la mémoire qui est en vis-à-vis de l'électrode supérieure considérée, embrasse une partie du pourtour de cette électrode supérieure. Cette surface est donc égale à la longueur de la portion mémoire/électrode en contact par l'épaisseur de l'électrode.

Par exemple, lorsque la mémoire embrasse trois des quatre côtés de l'électrode supérieure considérée, sa surface S est égale à :

$$S = w(L + 2\,l)$$

où L est la longueur d'un grand côté de l'électrode, par exemple égale à la finesse F, $l$ est la longueur de deux petits côtés de l'électrode, par exemple égale à F/2 et w est l'épaisseur de l'électrode, par exemple égale à F/4. La surface S (surface effective de la mémoire) est selon cet exemple égale à :

$$S = 1/2\,F^2 < F^2$$

Les mémoires, par exemple de type OxRAM, bénéficient avantageusement de cette réduction de surface. En effet, elles peuvent montrer une résistance à l'état haut plus importante à mesure que sa surface est réduite. Modifier la résistance à l'état haut de la mémoire (de manière à l'augmenter) permet notamment d'augmenter la fenêtre de lecture de l'ensemble sélecteur/mémoire.

De la même manière, chaque sélecteur peut également présenter une surface réduite, également inférieure à $F^2$. En effet, la fabrication d'un sélecteur selon l'art antérieur, c'est à dire aligné dans le plan, est limitée par la finesse de gravure F. La plus petite surface d'un sélecteur selon l'art antérieur fabricable est donc supérieure ou égale à $F^2$.

Pour chacun des deux sélecteurs de l'empilement sélecteur, sa surface est égale à la surface d'une électrode supérieure s'étendant sur la première couche active. Par exemple, pour une électrode supérieure présentant un grand côté de longueur F et un petit côté de longueur F/2, la surface S du sélecteur est également égale à :

$$S = 1/2\,F^2 < F^2$$

En outre, dans cette géométrie, la surface *effective* du sélecteur peut être rendue encore plus petite par un décalage latéral entre électrode supérieure et électrode inférieure.

Les sélecteurs, par exemple ovoniques, bénéficient avantageusement de cette réduction de surface, permettant par exemple de réduire leur courant de fuite et également leurs courants de seuil et de maintien lorsque leurs dimensions sont inférieures à une valeur limite, généralement de l'ordre de 80 nm.

Outre les caractéristiques qui viennent d'être évoquées dans le paragraphe précédent, l'ensemble selon l'invention peut présenter une ou plusieurs caractéristiques complémentaires parmi les suivantes, considérées individuellement ou selon toutes les combinaisons techniquement possibles :

- l'ensemble comprend une électrode inférieure, qui s'étend sous la première couche active, parallèlement à celle-ci, et qui est en contact électrique avec une face inférieure de la première couche active ;

- une partie au moins de la première électrode supérieure est située à l'aplomb de l'électrode inférieure, en se superposant à l'électrode inférieure, en projection selon une direction perpendiculaire audit plan ;

- une partie au moins de la deuxième électrode supérieure est située à l'aplomb de l'électrode inférieure, en se superposant à l'électrode inférieure, en projection selon une direction perpendiculaire audit plan ;

- au moins une des électrodes supérieures se superpose uniquement en partie à l'électrode inférieure ;

- les première et deuxième électrodes supérieures sont séparées l'une de l'autre, selon une direction horizontale donnée, par un écart donné ;

- selon ladite direction, la première électrode supérieure se superpose à l'électrode inférieure sur une distance qui est inférieure audit écart ;

- selon ladite direction, la première électrode supérieure se superpose à l'électrode inférieure sur une distance qui est supérieure audit écart ;

- la première couche active s'étend latéralement au-delà de l'électrode inférieure, en débordant sur une couche diélectrique qui entoure l'électrode inférieure ;

- la première couche active est délimitée latéralement par une surface latérale, et l'ensemble comprend en outre un espaceur électriquement isolant qui s'étend au moins contre la surface latérale de la première couche active, en recouvrant au moins en partie cette surface latérale ;

- l'espaceur recouvre aussi, en partie uniquement, la surface latérale d'au moins une des première et deuxième électrodes supérieures ;

- les première et deuxième électrodes supérieures sont au contact direct de la première couche active (c'est-à-dire sans couche intermédiaire entre elles) ;

- le premier empilement planaire comprend une couche isolante qui s'étend au-dessus des première et deuxième électrodes supérieures ;

- la couche isolante est divisée en une première partie et en une deuxième partie, la première partie de la couche isolante recouvrant la première électrode supérieure tandis que la deuxième partie de la couche isolante recouvre la deuxième électrode supérieure ;

- l'ensemble comprend un quatrième empilement, planaire, disposé sur la couche isolante, le quatrième empilement comprenant :

  - une quatrième couche active qui s'étend parallèlement audit plan, la quatrième couche active étant une couche sélectrice ;
  - une troisième et une quatrième électrodes qui s'étendent parallèlement audit plan, entre la quatrième couche active et la couche isolante, et qui sont isolées électriquement l'une de l'autre, la troisième électrode étant délimitée latéralement par une surface latérale, la quatrième électrode étant délimitée latéralement par autre une surface latérale, une couche isolante s'étendant entre une partie de la surface latérale de la troisième électrode et une partie de la surface latérale de la quatrième électrode pour isoler électriquement la troisième électrode de la quatrième électrode ;

- la deuxième couche active se prolonge au-delà de la surface latérale de la première électrode supérieure, en s'étendant le long d'une partie de la surface latérale de la troisième électrode ;

- la troisième couche active se prolonge au-delà de la surface latérale de la deuxième électrode supérieure en s'étendant le long d'une partie de la surface latérale de la quatrième électrode ;

- le quatrième empilement comprend :

  - une cinquième électrode, qui s'étend au-dessus de la quatrième couche active, en contact électrique avec la quatrième couche active, et

  - un troisième espaceur électriquement isolant qui recouvre une surface latérale de la cinquième électrode ;

- la première couche active, commune aux deuxième et troisième empilements, est continue, d'un seul tenant ;

- la première couche active est divisée en une première partie et une deuxième partie disjointes, la première partie de la couche active s'étendant sous la première électrode supérieure, la deuxième partie de la couche active s'étendant sous la deuxième électrode supérieure.

L'invention concerne en outre une matrice de mémoires résistives comprenant une pluralité d'ensembles tels que décrit ci-dessus, dans laquelle, pour chaque ensemble :

- le premier empilement planaire de l'ensemble est relié électriquement à une ligne d'adressage de la matrice,
- les deuxième et troisième empilements verticaux de l'ensemble sont reliés électriquement, respectivement, à deux colonnes d'adressage de la matrice, les deux colonnes d'adressage étant distinctes.

L'invention concerne également un procédé de fabrication d'un ensemble comprenant au moins deux mémoires résistives non volatiles disposées électriquement en parallèle entre elles et étant chacune électriquement connectées en série, à une couche sélectrice formant respectivement au moins deux sélecteurs, chacun dédié à l'une des mémoires selon la revendication indépendante de procédé 15.

Les étapes de formation des deuxième et troisième empilements peuvent être réalisées en exécutant les étapes suivantes :

- dépôt conforme d'une couche active globale, une première partie de la couche active globale s'étendant en vis-à-vis de la surface latérale de la première électrode supérieure, la première partie de la couche active globale étant en contact électrique avec la première électrode supérieure, une deuxième partie de la couche active globale s'étendant en vis-à-vis de la surface latérale de la deuxième électrode supérieure, la deuxième partie de la couche active globale étant en contact électrique avec la deuxième électrode supérieure ;
- séparer la couche active globale en au moins ladite deuxième couche active et ladite une troisième couche active, disjointes.

Les caractéristiques optionnelles, présentées plus haut en termes de dispositif (pour l'ensemble décrit ci-dessus), peuvent aussi s'appliquer au procédé qui vient d'être présenté.

L'invention et ses différentes applications seront mieux comprises à la lecture de la description qui suit et à l'examen des figures qui l'accompagnent.

## BRÈVE DESCRIPTION DES FIGURES

Les figures sont présentées à titre indicatif et nullement limitatif de l'invention. Sauf précision contraire, un même élément apparaissant sur des figures différentes est repéré par le même signe de référence.

[Fig.1a] et [Fig.1b] représentent schématiquement, selon une coupe et une vue de dessus, un premier mode de réalisation d'un ensemble comprenant deux mémoires résistives non volatiles et deux sélecteurs selon l'invention.

[Fig.2] représente schématiquement un mode de réalisation d'une matrice d'ensembles selon l'invention.

[Fig.3] représente schématiquement, selon une coupe, un développement du premier mode de réalisation de l'ensemble selon l'invention.

[Fig.4] représente schématiquement, selon une coupe, un deuxième mode de réalisation de l'ensemble selon l'invention.

[Fig.5] représente schématiquement, selon une coupe, un troisième mode de réalisation de l'ensemble selon l'invention.

[Fig.6] représente schématiquement, selon une coupe, un quatrième mode de réalisation de l'ensemble selon l'invention.

[Fig.7a] à [Fig.11b] représentent schématiquement, selon une coupe et une vue de dessus, des étapes du procédé de fabrication d'un ensemble selon l'invention.

## DESCRIPTION DÉTAILLÉE

L'invention concerne notamment un ensemble 1 comprenant au moins deux mémoires résistives non volatiles et deux sélecteurs, chacun associé en série à l'une de ces mémoires. L'ensemble 1 selon l'invention permet d'ajuster les propriétés électriques de ces mémoires et de ces sélecteurs de manière indépendante, tout en présentant un encombrement réduit.

Pour cela, l'ensemble 1 mutualise un premier empilement planaire 10, parallèle à un plan horizontal donné, P, et au moins deux empilements 20, 30 distincts, dont une partie au moins s'étend de manière oblique par rapport au plan P en question, par exemple de manière verticale. Dans la suite, on indiquera par planaire, ou horizontale une orientation parallèle audit plan P (par exemple parallèle à mieux que 5 degrés prés). Le plan P est question est par exemple parallèle à un substrat sur lequel l'ensemble 1 est réalisé. On indiquera par oblique, une orientation présentant un angle de 90° ± 45° par rapport au plan P, autrement dit un angle compris entre 45° et 135° par rapport au plan P. Et l'on indiquera par verticale une orientation présentant un angle de 90° ± 30° par rapport au plan P et de préférence 90° ± 5°. En l'occurrence, dans les exemples décrits ici en référence aux figures, une partie au moins des deuxième et troisième empilements 20, 30 s'étend verticalement (perpendiculairement au plan P). En variante, chacun de ces deux empilements pourrait toutefois être orienté différemment, en s'étendant par exemple parallèlement à un plan faisant un angle de 60 degrés avec ledit plan P horizontal (ou, plus généralement, un angle compris entre 60 et 80 degrés, par exemple).

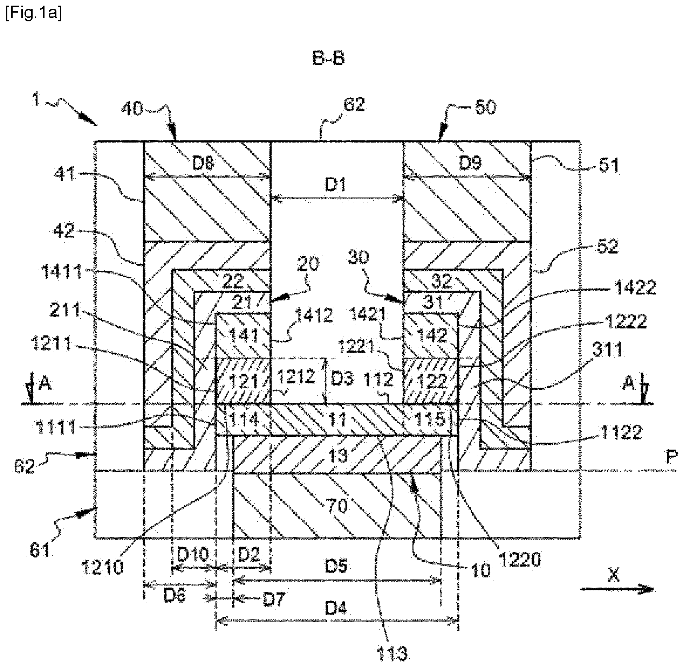

Dans les premier, deuxième, troisième et quatrième modes de réalisation décrits plus bas (et représentés, respectivement, sur les figures 1a, 4, 5 et 6), le premier empilement planaire 10 est un empilement sélecteur (par exemple de type « back-end » et co-intégrable en série avec les mémoires dans le BEOL), tandis que les deux empilements « verticaux » 20, 30 sont des empilements mémoire. En pratique, une telle configuration, dans laquelle les deuxième et troisième empilements sont des empilements mémoire tandis que le premier empilement est un empilement sélecteur, permet de limiter la surface occupée par l'ensemble 1, parallèlement au plan P. En effet, les empilement mémoire sont généralement moins épais que l'empilement sélecteur.

Le premier empilement planaire 10 comprend deux électrodes supérieures 121, 122, séparées l'une de l'autre, sans contact électrique direct entre elles. Chaque électrode supérieure 121, 122 est reliée électriquement à un des empilements verticaux 20, 30. Cet agencement, correspond à deux circuits mémoire/sélecteur de type 1S1R indépendants.

D'un point de vue électrique, les deuxième et troisième empilements 20, 30 sont en quelque sorte, disposés en parallèle entre eux, puisque, d'un côté, ils sont tous deux reliés en série à un empilement sélecteur commun. On notera néanmoins que, de l'autre côté, ces deux empilements mémoire 20, 30 sont reliés à des contacts électriques (40 et 50) distincts, isolés électriquement l'un de l'autre.

Comme déjà indiqué, une partie au moins de l'empilement mémoire 20 s'étend parallèlement à un plan vertical. Cette partie de l'empilement 20 s'étend en vis-à-vis d'une première partie 1211 d'une surface latérale 1211, 1212 qui délimite latéralement la première électrode supérieure 121. Cette partie de l'empilement 20 s'étend ici parallèlement à cette première partie 1211 de surface latérale (parallèlement à mieux que 5 ou 10 degrés, par exemple).

De même, une partie au moins de l'empilement mémoire 30 s'étend parallèlement à un plan vertical. Cette partie de l'empilement 30 s'étend en vis-à-vis d'une deuxième partie 1222 d'une surface latérale 1221, 1222 qui délimite latéralement la deuxième électrode supérieure 122. Cette partie de l'empilement 30 s'étend ici parallèlement à cette deuxième partie 1222 de surface latérale.

Dans l'ensemble 1, les différentes couches (dont les électrodes) qui s'étendent parallèlement au plan P sont délimitées latéralement, chacune, par une (ou éventuellement des) surface latérale, verticale ou tout au moins obliques par rapport au plan P. Cette ou ces surfaces latérales sont aussi appelées flanc ou « flancs » dans la suite. Dans la suite, pour certaines couches, il est indiqué que la couche considérée est délimitée latéralement par une surface latérale comprenant deux parties (i.e. : par un premier et deuxième flanc, ici), en pratique situées à l'opposé l'une de l'autre. La surface latérale en question peut néanmoins être continue, et faire tout le tour de l'électrode sans discontinuité, par exemple lorsque le bord de cette couche est circulaire (cette surface latérale étant alors cylindrique) ; dans ce cas, les deux portions en question correspondent à deux portions de cette surface continue, situées à l'opposée l'une de l'autre. Ces deux parties de la surface latérale de la couche peuvent aussi correspondre à deux faces distinctes du pourtour de la couche en question, lorsque ce pourtour est par exemple rectangulaire, comme ici (rectangulaire vu du dessus de la couche).

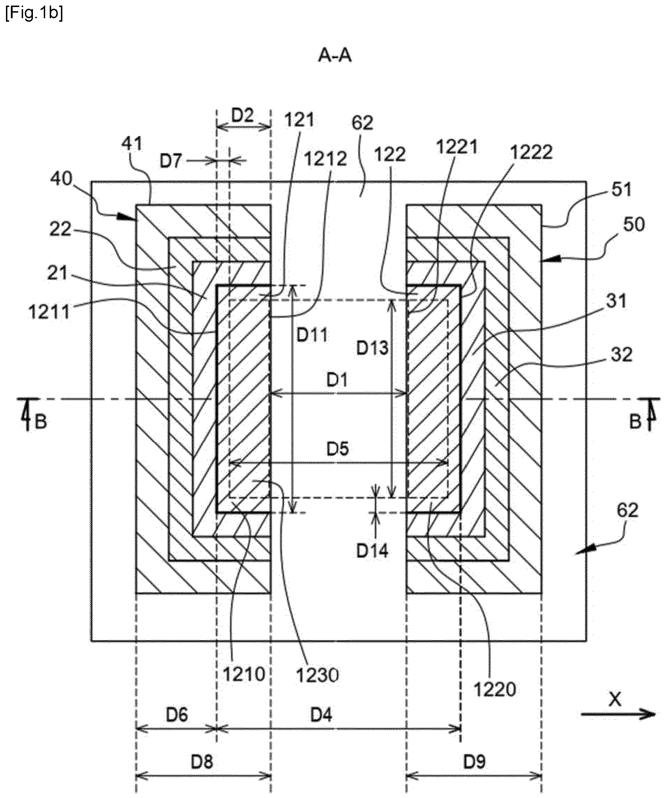

Les [Fig.1a] et [Fig.1b] représentent schématiquement, respectivement en coupe et vu de côté, le premier mode de réalisation de l'ensemble 1. Le premier empilement 10 comprend notamment :

- une première couche active 11 ;

- la première électrode supérieure 121, mentionnée plus haut ; et

- la deuxième électrode supérieure 122.

La première couche active 11 s'étend parallèlement au plan P. Le plan P correspond par exemple à la surface d'une couche diélectrique 61 sur laquelle l'ensemble 1 peut reposer (on notera toutefois que, à la fin de la fabrication, la couche diélectrique 61 peut faire partie d'un enrobage diélectrique global, de protection, dans lequel l'ensemble est enrobé).

Les première et deuxième électrodes supérieures 121, 122 s'étendent sur la première couche active 11. La première couche active 11 est délimitée par une surface supérieure 112 et une surface inférieure 113, opposée à la surface supérieure 112. Chaque électrode supérieure 121, 122 s'étend par exemple sur la surface supérieure 112 de la première couche active 11, contre celle-ci. La surface inférieure 113 de la première couche active 11 repose par exemple, au moins en partie, sur la couche diélectrique 61, parallèlement au plan P.

La première électrode supérieure 121 est délimitée latéralement par la surface latérale mentionnée plus haut. Ladite surface latérale comprend une première partie (ou portion) appelée premier flanc 1211 dans la suite. La première électrode supérieure 121 peut, comme ici, avoir une forme d'ensemble rectangulaire. Elle est alors délimitée latéralement par quatre parties de la surface latérale (dont le premier flanc 1211, et une autre partie, opposée, appelée cinquième 1212 flanc dans la suite), correspondant aux quatre côtés de ce rectangle.

De la même manière, la deuxième électrode supérieure 122 est délimitée latéralement par la surface latérale mentionnée plus haut, dont une partie est appelée deuxième flanc 1222. La deuxième électrode supérieure 122 peut également avoir une forme d'ensemble rectangulaire. Elle est alors délimitée latéralement par quatre parties de ladite surface latérale (dont le deuxième flanc 1222, et une autre partie, opposée, appelée sixième flanc 1221 dans la suite), correspondant aux quatre côtés de ce rectangle.

La première couche active 11 est délimitée latéralement, elle aussi, par une surface latérale, comprenant au moins deux parties, opposées l'une à l'autre, appelées troisième flanc 1111 et quatrième flanc 1122. Les troisième et quatrième flancs 1111, 1122 peuvent être situés dans le prolongement des premier et deuxième flancs 1211 et 1222 des première et deuxième électrodes supérieures 121, 122 ; dans ce cas, le premier flanc 1211 (de la première électrode supérieure 121), et le troisième flanc 1111 (de la première couche active 11) forment un même flanc, global, du premier empilement planaire 11 dans son ensemble (résultant d'une gravure d'ensemble du premier empilement); de même, les deuxième et quatrième flancs 1222, 1122 forment alors un autre flanc, global, du premier empilement dans son ensemble. Ici, la première couche active a elle aussi une forme d'ensemble rectangulaire.

Le premier empilement planaire 10 réalise une fonction de sélection et la première couche active 11 est une couche sélectrice. C'est à dire qu'elle est configurée pour modifier sa conductivité en fonction d'une tension appliquée entre ses surfaces supérieure et inférieure 112, 113, et/ou en fonction d'un courant électrique circulant entre ces surfaces 112, 113. On définit une tension seuil au-delà de laquelle la première couche active 11 est dans un état dit « passant ». C'est à dire qu'une partie au moins de la première couche active 11 est alors conductrice. Par conductrice, on entend que sa résistance est inférieure à 10 k$\Omega$. En deçà de la tension seuil, la couche sélecteur 11 est dans un état dit « bloqué ». C'est à dire que la résistance de la première couche active 11 est par exemple supérieure ou égale à 100 k$\Omega$ au moins. Certains types de couche active 11 peuvent toutefois présenter une résistance variant en fonction de la tension appliquée entre ses surfaces supérieure et inférieure 112, 113. La résistance peut varier exponentiellement de sorte qu'elle soit de l'ordre de 10 $k\Omega$ ou de quelques dizaines de k$\Omega$ juste avant la commutation de l'état bloqué à l'état passant. L'état passant est préférentiellement métastable. C'est à dire que la première couche active 11 est initialement dans l'état bloqué et qu'elle ne présente un état passant que lorsqu'une tension appliquée entre ces surfaces supérieure et inférieure 112, 113 devient supérieure à la tension seuil. La première couche active 11 peut conserver un état passant tant qu'un courant ou une tension appliquée sur ladite couche 11 est supérieure à un courant de maintien donné.

La première couche active 11 comprend par exemple un chalcogénure, par exemple un alliage à base de sélénium, germanium, antimoine et azote. Auquel cas, le premier empilement planaire 10 est alors un sélecteur ovonique ou OTS pour « Ovonic Threshold Switching » en anglais.

La première couche active 11 peut également comprendre un matériau tel que le premier empilement planaire 10 soit un sélecteur à pont conducteur instable ou TS pour « Threshold Switch » en anglais, ou un sélecteur à conduction électronique et ionique ou MIEC pour « Mixed ion-electronic conduction » en anglais ou encore un sélecteur à transition métal-isolant. Dans ces cas, les première et deuxième électrodes supérieures peuvent être des électrodes actives de l'empilement sélecteur.

La première électrode supérieure 121 est conductrice. Elle comporte une ou plusieurs couches, parallèles au plan P. L'une de ces couches peut être métallique. Une autre de ces couches peut être une couche permettant d'éviter la diffusion d'espèces dans la première couche active 11. À titre d'exemple, cette électrode peut comprendre une couche en carbone intercalée entre une couche en nitrure de titane et la première couche active 11.

Dans ce premier mode de réalisation, la première électrode supérieure 121 s'étend sur une première portion 1210 seulement de la surface supérieure 112 de la première couche active 11, en particulier au niveau d'une première portion 114 de la première couche active 11 (une partie de la portion 114 étant située à l'aplomb d'une électrode inférieure 13).

La deuxième électrode supérieure 122 est également conductrice. Elle comporte, de la même manière que la première électrode supérieure 121, une ou plusieurs couches, parallèles au plan P. Dans ce premier mode de réalisation, la deuxième électrode supérieure 122 s'étend sur une deuxième portion 1220 de la surface supérieure 112 de la première couche active 11, en particulier au niveau d'une deuxième portion 115 de la première couche active 11 (une partie de la deuxième portion 115 étant également située à l'aplomb de l'électrode inférieure 13).

Les cinquième et sixième flancs 1212 et 1222 sont en vis-à-vis l'un de l'autre et au moins espacées d'une première distance D1 (correspondant par exemple à la largeur d'une tranchée séparant ces deux électrodes, obtenue par gravure). Les cinquième et sixième flancs 1212 et 1222 sont également séparés par une couche isolante 62, isolant électriquement les électrodes 121, 122 entre elles. En effet, l'ensemble 1 finalisé est enterré dans un matériau diélectrique 62 permettant d'isoler différents éléments entre eux, dont les première et deuxième électrodes 121, 122.

Comme déjà indiqué, le deuxième empilement 20, vertical, joue ici un rôle de mémoire. Il permet de stocker une information de manière non volatile. L'information est par exemple encodée sous la forme d'une valeur de résistance d'une couche active dudit deuxième empilement vertical 20. Le deuxième empilement vertical 20 peut être de type de PCRAM, CBRAM, OxRAM ou MRAM telle que décrit dans lors de la présentation de l'art antérieur. Le deuxième empilement vertical 20, comprend pour cela au moins une deuxième couche active 21. La deuxième couche active 21 peut présenter un état dit « bas », c'est à dire une résistance faible, par exemple inférieure à une résistance de l'ordre de 10 k$\Omega$, voire de 10 $k\Omega$, ou un état dit « haut », c'est à dire une résistance élevée, par exemple supérieure à 50 k$\Omega$. La deuxième couche active 21 passe de l'état haut à l'état bas lorsqu'une tension, appliquée à cette couche ou un courant circulant dans la couche, dépasse une tension/courant de programmation, dite également tension/courant de « set » en anglais. La deuxième couche active 21 passe de l'état bas à l'état haut lorsqu'une tension ou un courant appliqué à la couche dépasse une tension/courant d'effacement, dite également tension/courant de « reset » en anglais. La deuxième couche active 21 comprend par exemple une couche d'oxyde d'hafnium (en contact avec une couche en titane faisant office de réservoir à lacunes en oxygène), auquel cas le deuxième empilement vertical 20 réalise la fonction d'OxRAM.

De la même manière, le troisième empilement 30 comprend au moins une troisième couche active 31, permettant d'encoder une information sous la forme d'une valeur de résistance. Les caractéristiques électriques des deuxième et troisième couches actives 21, 31, dont au moins les tensions/courants de programmation et d'effacement, sont proches, voire identiques.

La réduction de l'encombrement de l'ensemble 1 résulte notamment du partage d'un même plot sélecteur pour deux mémoires, et de l'orientation oblique d'une partie au moins de la deuxième couche active 21, située en vis-à-vis du premier flanc 1211 de la première électrode supérieure 121, et d'une partie au moins de la troisième couche active 31, située en vis-à-vis du deuxième flanc 1222 de la deuxième électrode supérieure 122.

La première électrode supérieure 121 relie électriquement la première couche active 11 avec la deuxième couche active 21. De la même manière, la deuxième électrode supérieure 122 relie électriquement la première couche active 11 à la troisième couche active 31. Ainsi, la première couche active 11 est commune aux deuxième et troisième empilements verticaux 20, 30. En d'autres termes, c'est la même première couche active 11 qui est connectée électriquement à la deuxième couche active 11 d'une part et à la troisième couche active 31 d'autre part. Les deuxième et troisième couches actives 21, 31 sont séparées l'une de l'autre. Elles sont isolées électriquement l'une de l'autre car uniquement en contact par la première couche active 11.

Par isolés électriquement, on entend sans contact électrique direct entre eux. En d'autres termes, il n'y a pas d'élément, conducteur en toutes circonstances (par exemple métallique), les reliant directement.

La deuxième couche active 21 peut être reliée électriquement entre un premier contact électrique 40, supérieur, et la première électrode supérieure 121. De la même manière, la troisième couche active 31 peut être reliée électriquement entre un deuxième contact électrique 50, supérieur, et la deuxième électrode supérieure 122. Les premier et deuxième contacts 40, 50 sont isolés électriquement l'un de l'autre.

L'ensemble de mémoire et de sélecteur 1 peut être enterré dans un matériau diélectrique, par exemple un oxyde de remplissage isolant 62 tel qu'un oxyde de silicium.

La première électrode supérieure 121 s'étend sur la première portion 1210, dite première surface, de la surface supérieure 112 de la première couche active 11. Une partie au moins de la première portion 114 de la première couche active 11 est située à l'aplomb de la première surface 1210. La première électrode supérieure 121 influence la conduction électrique au niveau de la première portion 114. Par exemple, l'application d'une tension entre la première électrode supérieure 121 et la surface inférieure 113 de la première couche active 11, permet de faire passer la première portion 114 de la couche active de l'état bloqué à l'état passant (dès lors que la tension appliquée est supérieure à une tension de seuil du matériau considéré). La première portion 114 peut donc assurer, localement, une fonction de sélection.

De la même manière, la deuxième électrode supérieure 122 influence la conduction électrique au niveau de la deuxième portion 115 de couche active 11. La deuxième portion 115 peut donc également assurer, localement, une fonction de sélection.

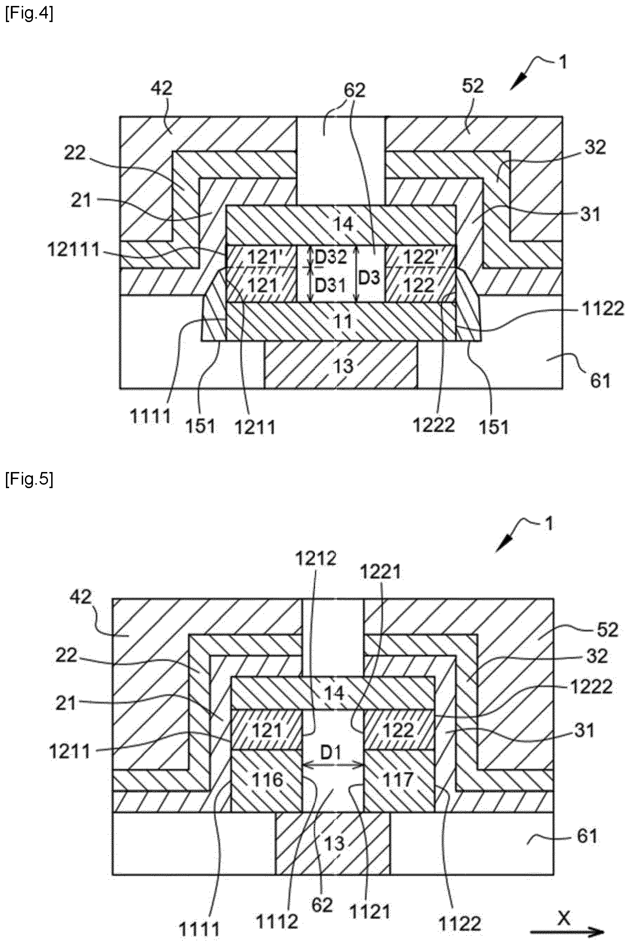

Puisque les première et deuxième électrodes supérieures 121, 122 sont séparées l'une de l'autre, les première et deuxième portions 114, 115 de la première couche active 11 sont donc également séparées l'une de l'autre (sauf si les dimensions de la région de conduction sont proches ou supérieures à la distance séparant les deux électrodes supérieure, auquel cas les première et deuxième portions 114, 115 de la première couche active 11 peuvent être trop proches et il pourra être souhaitable de séparer la couche active 11 en deux parties distinctes, comme dans le cas de la figure 5, afin d'obtenir deux sélecteurs indépendants). La première couche active 11 comprend donc deux portions 114, 155 assurant chacune la fonction de sélection et pouvant être opérées indépendamment. En d'autres termes, le premier empilement planaire 10 comprend deux sélecteurs. Chaque sélecteur est dédié à un empilement mémoire.

L'ensemble 1 comprend ainsi deux circuits mémoire/sélecteur de type 1S/1R (le sélecteur étant connecté en série de l'élément mémoire résistif), opérables indépendamment l'un de l'autre.

La disposition de la première portion 114 dépend de l'agencement de la première électrode supérieure 121 sur la première couche active 11 et donc de la position et des dimensions de la première surface 1210. Dans l'exemple de la [Fig.1a], la première électrode supérieure 121 s'étend le long d'un bord de la surface supérieure 112 de la première couche active 11. Le bord en question est notamment disposé à l'aplomb des premiers et troisième flancs 1111, 1211. La première électrode supérieure 121 s'étend, à partir de ce bord sur une deuxième distance D2. La deuxième distance D2 est mesurée perpendiculairement audit bord.

La première surface 1210 s'étend donc également, à partir de ce bord, sur la deuxième distance D2.

Les propriétés électriques de la première portion 114 dépendent en partie de ses dimensions. La structure particulière de l'ensemble 1 permet ainsi d'ajuster les propriétés électriques du sélecteur associé à la première portion 114, en fonction de l'agencement de la première électrode supérieure 121 sur la première couche active 11, en particulier en fonction de l'étendue de cette première électrode, et en fonction de son positionnement plus ou moins à l'aplomb de l'électrode inférieure 13.

De la même manière, l'ensemble 1 permet d'ajuster les propriétés électriques du sélecteur associé à la deuxième portion 115, en fonction de l'agencement de la deuxième électrode supérieure 121 sur la première couche active 11.

Une portion de la deuxième couche active 21, appelée troisième portion 211, est en contact avec le premier flanc 1111 de la première électrode supérieure 121. La première électrode supérieure 121 peut également influencer la conduction électrique au niveau de cette troisième portion 211. Par exemple, l'application d'une tension entre la première électrode supérieure 121 et une surface opposée de la deuxième couche active 21, permet de faire passer la troisième portion 211 de son état hautement résistif à son état bassement résistif. La troisième portion 211 assure donc, localement, une fonction de mémoire non-volatile.

Les propriétés électriques de la troisième portion 211 dépendent également en partie de ses dimensions. Ses dimensions de la troisième portion 211 dépendent notamment de la surface (i.e. : de l'aire) du premier flanc 1111. L'ajustement de la surface du premier flanc 111, obtenu par exemple en ajustant l'épaisseur de la couche 121, permet donc d'ajuster les propriétés électriques de la mémoire non-volatile associée à la troisième portion 211. La surface du premier flanc 1111 est par exemple ajustable en fonction de l'épaisseur D3 de la première électrode supérieure 121.

L'ensemble 1 permet donc d'ajuster de manière indépendante les dimensions du sélecteur associé à la première portion 111 et de la mémoire non-volatile associée à la troisième portion 211. Ainsi, les propriétés électriques dudit sélecteur et de ladite mémoire peuvent être ajustées indépendamment.

Le même raisonnement s'applique à la quatrième portion 311 (portion de la troisième couche active 31). L'ajustement de la surface (i.e. : de l'étendue surfacique) du deuxième flanc 1222 permet d'ajuster les propriétés électriques d'une mémoire non-volatile associée à la quatrième portion 311.

L'ensemble 1, comprenant deux circuits 1S1R, permet d'ajuster de manière indépendante les propriétés électriques de chaque sélecteur et de chaque mémoire.

Le premier empilement planaire 10 comprend une électrode inférieure 13, en contact avec la surface inférieure 113 de la première couche active 11. Une partie de la première électrode supérieure 121 s'étend en vis-à-vis d'une partie de l'électrode inférieure 13. En d'autres termes, la partie de la première électrode supérieure 121 se superpose par projection verticale à l'électrode inférieure 13. Par projection verticale, on entend suivant une direction verticale telle que précédemment définie.

Ici, une partie seulement de la première électrode supérieure 121 se superpose à l'électrode inférieure 13. Ainsi, le cinquième flanc 1212 est situé au-dessus de l'électrode inférieure 13, à l'aplomb de celle-ci, tandis que le premier flanc 1211 est décalé latéralement par rapport à l'électrode inférieure 13 et n'est pas situé à l'aplomb de l'électrode inférieure 13, au-dessus de celle-ci. Par à l'aplomb, on entend aligné selon une direction verticale. Le sélecteur associé à la première portion 114 de la couche active 114 s'établi alors entre les surfaces en regard 1230 (i.e. : en superposition) de la première électrode supérieure 121 et l'électrode inférieure 13. Le décalage latéral entre la première électrode supérieure 121 et l'électrode inférieure 13 permet (de même que la largeur réduite D2 de l'électrode supérieure) d'obtenir, pour le sélecteur en question, une surface effective (en l'occurrence une surface sur laquelle il y a superposition entre les électrodes 121 et 13) plus petite que $F^2$ où F est une finesse de gravure de la technologie de fabrication considérée au niveau considéré dans le BEOL. Le fait que l'on puisse obtenir une surface inférieure à $F^2$ est surprenant à priori. Cela résulte notamment de la structure géométrique particulière de l'ensemble 1, et du fait que les précisions d'alignement, lors de gravures ou dépôt (précision par exemple meilleure que 15nm), peuvent être meilleures que la finesse F (par exemple égale à une quarantaine de nm).

L'aire $S_{1230}$ de la surface 1230 en regard de la première électrode 121 peut alors s'exprimer comme (voir la figure 1b) :

$$S_{1230} = D13 \times (D2 - D7)$$

En considérant par exemple D2 = 2/3 F, D7 = 1/2 F et D13 = 2 F, la surface 1230 est alors égale à 1/3 $F^2$, nettement inférieur à $F^2$ (D13 est la largeur de l'électrode inférieure 13, parallèlement au plan P, et selon une direction perpendiculaire à X - donc selon une direction perpendiculaire à celle correspondant à la largeur D5).

De même, une partie seulement de la deuxième électrode supérieure 122 s'étend ici en vis-à-vis d'une partie de l'électrode inférieure 13 (ou par projection verticale à celle-ci), à l'aplomb de celle-ci. Le sixième flanc 1221 est situé au-dessus de l'électrode inférieure 13, à l'aplomb de cette dernière, tandis que le deuxième flanc 1222 est décalé latéralement par rapport à l'électrode inférieure 13 : il n'est pas situé à l'aplomb de l'électrode inférieure 13 (il n'est pas situé au-dessus de celle-ci).

Une certaine variabilité des caractéristiques électriques du premier empilement planaire 10 peut être causée par des étapes de fabrication dudit empilement 10 ou des empilements verticaux 20, 30 introduisant des défauts dans une partie de la première couche active 11. Les défauts sont généralement localisés au niveau des flancs de la première couche active 11 (donc notamment au niveau des troisième et quatrième flancs 1111, 1122), exposés à des étapes de gravure ou de dépôt. Les caractéristiques électriques au niveau de ces flancs sont alors modifiées localement. Il est alors prévu d'éloigner les troisième et quatrième flancs 1111, 1122 l'un de l'autre, pour qu'ils soient séparés par une troisième distance D4, supérieure à une largeur D5 de l'électrode inférieure 13. Ainsi, chaque sélecteur associé aux portions 114, 115 de la première couche active, est alors éloigné des flancs 1111, 1122 de la première couche active 11. Ils sont donc peu influencés par les caractéristiques électriques au niveau des troisième et quatrième flancs 1111, 1122. Chaque sélecteur présente ainsi une variabilité minimale de ses caractéristiques électriques.

La première distance D1 séparant les première et deuxième électrodes supérieures 121, 122 est par exemple comprise entre 40 nm et 90 nm. En effet, dans une première couche active 11 ovonique, un canal de conduction métastable peut présenter une étendue planaire pouvant être comprise entre 40 nm et 60 nm (et qui dépasse rarement 80 nm). En augmentant ainsi la première distance D1 séparant les électrodes supérieures, on réduit l'influence que les sélecteurs peuvent avoir entre eux.

La troisième distance D4 séparant les troisième et quatrième flancs 1111, 1122 est par exemple comprise entre 60 nm et 110 nm, voire entre 80 nm et 100 nm. On réduit ainsi la variabilité des caractéristiques électriques de l'empilement sélecteur, fixées par celles des canaux de conduction, situé loin des flancs (loin des bords).

L'orientation en partie verticale des deuxième et troisième empilements 20, 30, et l'utilisation d'une première couche active 11 commune, planaire, permet d'écarter les troisième et quatrième flancs 1111, 1122 l'un de l'autre, comme indiqué ci-dessus, pour réduire les problèmes de variabilité, sans augmenter l'encombrement de l'ensemble 1, par rapport à des dispositifs 1R1S de l'art antérieur, en tout cas du point de vue de l'encombrement selon la direction X représentée sur la figure 1a (direction parallèle au plan P, et dirigée du premier flanc vers le deuxième flanc, ici perpendiculaire à chacun de ces deux flancs). Cet aspect est expliqué plus en détail ci-dessous.

Dans la direction X, chaque empilement vertical 20, 30 s'étend, à partir du premier flanc 1111 de la première électrode supérieure 12, sur une quatrième distance D6. Dans le premier mode de réalisation, cette distance correspond en quelque sorte à l'épaisseur totale du deuxième l'empilement 20 et d'une couche métallique optionnelle 42 qui le recouvre. Par ailleurs, le premier flanc 1111 est décalé latéralement, par rapport à l'électrode inférieure 13, d'une cinquième distance D7, non nulle. De même, le deuxième flanc 1222 est décalé latéralement, par rapport à l'électrode inférieure 13 de la même cinquième distance D7. On a donc D4 = D5+2·D7. La première électrode supérieure 121 ne se superpose donc que partiellement à l'électrode inférieure 13.

En pratique, la largeur D5 de l'électrode inférieure 13 est au moins égale à la finesse de gravure, F, finesse qui vaut par exemple 40 nm. La finesse impose notamment une largeur minimum à un via inférieur 70, traversant la couche diélectrique 61 pour connecter l'électrode inférieure 13. La largeur D5 de l'électrode inférieure 13 et une largeur du via inférieur 70 sont ici égales l'une à l'autre. La largeur D5 est donc au moins égale à la finesse F.

La première distance D1, séparant les première et deuxième électrodes supérieures 121, 122 dépend avantageusement de la largeur D5 de l'électrode inférieure 13. Afin de permettre un vis-à-vis entre les électrodes supérieures 121, 122 et l'électrode inférieure 13, la première distance D1 est préférentiellement strictement inférieure à la largeur D5. Dans la pratique, les canaux de conduction peuvent tout de même s'établir si aucun vis-à-vis n'existe entre les électrodes supérieures 121, 122 et l'électrode inférieure 13. En revanche, ce cas de figure peut augmenter la variabilité des canaux de conduction s'établissant dans la première couche active 11.

De même, les premier et deuxième contact électrique 40, 50 présentent respectivement une largeur D8 et D9 au moins égale à cette finesse F (i.e. : limitée par la finesse F), et séparés par la première distance D1.

Dimensionner l'ensemble de sorte que la somme D6+D2 soit, comme ici, inférieure ou égale à la largeur D8 (largeur selon la direction X) du premier contact supérieur 40 permet alors de loger sous ce contact le deuxième empilement 20, ainsi que la partie de le premier empilement planaire 10 qui déborde latéralement au-delà de l'électrode inférieur 13. L'encombrement de l'ensemble 1 prend en compte une distance supplémentaire, due à l'espace séparant l'ensemble de ses proches voisins (espace dit « metal pitch » en anglais). Ladite distance est égale à F (F/2 de chaque côté de l'ensemble 1). Ainsi, selon la direction X, l'encombrement est donc de 4F et cela alors même que la première couche active 11 a une extension latérale supérieure à F (pour limiter l'influence indésirables des bords de couche).

À titre d'exemple, est en fonction d'une finesse de gravure F, l'ensemble 1 peut présenter les dimensions suivantes :

- D1 = F ;

- D2 = 3/4 F ;

- D3 = 10 nm ;

- D4 = 2,5 F ;

- D5 = 1,5 F ;

- D6 = 3/4 F ;

- D7 = 1/2 F ;

- D8 = D9 = 1,5 F ;

- D10 = 10 nm ;

- D11 = 2,5 F ;

- D13 = F ; et

- D14 = 1/2F.

D11 est la largeur des électrodes supérieures 121, 122, parallèlement au plan P, et selon une direction perpendiculaire à X - donc selon une direction perpendiculaire à celle correspondant à la largeur D5. La surface latérale des électrodes supérieurs 121, 122 est décalée latéralement par rapport à l'électrode inférieure 13 d'une distance D11 selon la direction perpendiculaire à X.

La surface totale $S_{\text{TOT}}$ occupée par l'ensemble 1 (c'est-à-dire son empreinte, incluant une zone périphérique entourant l'ensemble, et qui s'arrête à mi-distance entre cet ensemble et les ensembles voisins) peut s'exprimer comme :

$$S_{\text{TOT}} = (MP + D8 + D9 + D1) \times (MP + D13 + 2 * D14)$$

où MP est un espace entre chaque ensemble, appelé « metal pitch » en anglais, par exemple égal à F.

D14 est égale à D7, en pratique. La surface totale $S_{\text{TOT}}$ est alors égale à 15 $F^2$, pour ces exemples de valeurs. Comme l'ensemble 1 comprend deux circuits 1S1R, une surface équivalente occupée $S_{\text{1S1R}}$, rapportée à un seul circuit 1S1R est donc égale à 7,5×F$^2$, ici. Cela est supérieur à la surface occupée pour un circuit 1S1R dans une réalisation classique purement planaire, pour laquelle cette surface peut être de 4×F$^2$ (comprenant la zone périphérique mentionnée ci-dessus, qui entoure le point mémoire). En revanche, l'agencement présenté ici offre l'avantage de pouvoir ajuster, indépendamment, les surfaces de chaque mémoire et de chaque sélecteur (et d'avoir des surfaces effectives, pour les zones actives, qui soient inférieures à F$^2$).

Vue en coupe, la deuxième couche active 21, comprend par exemple une portion verticale et deux portions planaires, à chacune de ses extrémités. Vue en coupe, elle forme ainsi un « S » pouvant être logé sous le premier contact 40, au droit de celui-ci, sans en dépasser d'un point de vue latéral. Par au droit, on entend à l'aplomb.

Les deux portions planaires de la couche active 21 sont optionnelles. La couche active 21 pourrait être entièrement orientée verticalement et disposée sous le premier contact 40.

De la même manière, la troisième couche active 31, au moins en partie orientée verticalement, permet à la première couche active 11 et/ou la deuxième électrode supérieur 122 de s'étendre jusque sous le deuxième contact 50 sans pour autant augmenter l'encombrement d'ensemble de l'ensemble 1 (dans la direction X).

La densité de stockage offerte par une matrice de points mémoire dépend en partie de l'espacement imposé entre des lignes d'adressage deux à deux et/ou des colonnes d'adressage deux à deux. Plus cet espacement est faible et plus la densité de stockage de la matrice finale est élevée. Cet espacement, qui correspond à la première distance D1 entre les premier et deuxième contacts électriques 40, 50, destinés à être connectés aux lignes/colonnes d'adressage, ou qui forment directement ces lignes/colonnes d'adressage, est limité en pratique par la finesse F de gravure.

Le premier empilement planaire 10 est également relié électriquement au via inférieur 70 mentionné plus haut (ou à un autre élément conducteur équivalent). La couche diélectrique 61 sur laquelle repose le premier empilement planaire 10 est traversée par ce via inférieur 70. Le via inférieure 70 peut ainsi être relié électriquement à la surface inférieure 113 de la première couche active 11 par l'intermédiaire de l'électrode inférieure 13. Le via inférieure 70 et l'électrode inférieure 13 peuvent d'ailleurs être réalisés dans le même matériau et dans le prolongement l'un de l'autre, de sorte qu'ils soient en fait confondus. Ainsi, la première couche active 11 est reliée électriquement en série entre la première électrode supérieure 121 et le via conducteur 70 d'une part et la deuxième électrode supérieure 122 et le via conducteur 70 d'autre part. Pour un sélecteur de type OTS, l'électrode inférieure peut par exemple être à base de nitrure de titane, de nitrure de tantale, de tungstène, ou de nitrure de tungstène, voire de carbone.

Les électrodes supérieures 121, 122 et/ou l'électrode inférieure 13 peuvent être de natures différentes, dépendant par exemple du type de matériau mis en œuvre par la première couche active 11. En effet, certains sélecteurs peuvent requérir la mise en œuvre d'une ou plusieurs électrodes dites actives, pour fonctionner. Il s'agit par exemple des sélecteurs de type TS (pour « Threshold Switch » en anglais) ou MIEC (« Mixed ion-electronic conduction » en anglais). En effet, la conduction dans ces sélecteurs met en œuvre la diffusion ou la migration d'ions métalliques permettant de former, en présence d'un champ électrique, un filament conducteur. Par exemple, un sélecteur de type TS met en œuvre la diffusion d'ions métalliques tels que les ions argent. Ces ions peuvent être apportés par une électrode dite « active », au contact de la couche sélectrice et qui comprend de l'argent. Selon le même principe, un sélecteur de type MIEC met en œuvre la diffusion/migration d'ions métalliques tels que des ions cuivre, auquel cas, une électrode active au contact de la couche sélectrice comprend avantageusement du cuivre.

Selon le sens d'application de la tension ou de circulation du courant dans la première couche active 11, l'une ou/et l'autre des électrodes supérieures 121, 122 ou/et l'électrode inférieure 13 peut être « active » vis-à-vis de la première couche active 11, c'est à dire comporter des éléments contribuant à la conduction de la couche sélectrice 11. La ou les électrodes actives (électrodes supérieures 121, 122 et/ou électrode inférieure 13) peuvent alors comprendre de l'argent ou du cuivre. Les électrodes précitées comportent par exemple plusieurs couches dont au moins une, et si possible la couche en contact avec la première couche active 11, comprend de l'argent ou du cuivre.

La première couche active 11 peut également comporter une pluralité de couche dont une couche au moins, par exemple en contact avec une électrode, comporte des éléments contribuant à la conduction de la couche sélectrice. Il s'agit par exemple d'une couche en cuivre ou en argent, s'étendant sur une des faces supérieure ou inférieure 113, 114. Afin d'éviter que ladite couche en cuivre ou en argent ne court-circuite la première couche active 11 elle-même entre les électrodes supérieures 121, 122, elle pourra se présenter en deux parties, distinctes et isolées électriquement l'une de l'autre. La couche en cuivre ou en argent présente par exemple une première partie disposée sous la première électrode 121 et une seconde partie disposée sous la deuxième électrode 122, les première et deuxième partie de ladite couche étant par exemple séparée l'une de l'autre par un matériau isolant (tel que le matériau diélectrique 62).

L'électrode inférieure 13 s'étend sur une partie, ici sur une partie seulement de la face inférieure 114 de la première couche active 11.

Le deuxième empilement 20 peut, comme ici, comprendre une couche conductrice 22. La couche conductrice 22 relie électriquement la deuxième couche active 21 au premier contact supérieur 40. Elle est disposée ici entre la deuxième couche active 21 et le premier contact supérieur 40. Ici, la couche conductrice 22 s'étend sur la deuxième couche active 21, contre celle-ci. De manière avantageuse, une partie au moins de la couche conductrice 22 s'étend également parallèlement au premier flanc 1211 et en vis-à-vis de ce premier flanc 1211. Cette couche conductrice 22 peut comprendre une ou plusieurs sous-couches, jouant par exemple un rôle de couche réservoir pour des lacunes en oxygène (une telle couche étant par exemple réalisée en titane), ou un rôle de couche d'isolation s'opposant au passage d'oxygène (couche en nitrure de titane, par exemple), ou jouer encore un autre rôle dans le fonctionnement du deuxième empilement 20 en tant qu'empilement mémoire.

La couche conductrice 22 et la deuxième couche active 21 du deuxième empilement 20 s'étendent dans la portion en vis-à-vis du premier flanc, à une distance D10 avantageusement inférieure ou égale à 20 nm, voire 10 nm. Il s'agit, en d'autres termes, de la hauteur de la mémoire ou du sélecteur.

De la même manière, le troisième empilement vertical 30 peut comprendre une couche conductrice 32 reliant électriquement la troisième couche active 31 au deuxième contact supérieur 50.

Le premier contact électrique 40 peut comprendre un premier via supérieur 41 qui s'étend par exemple à la verticale du deuxième empilement 20. Afin d'améliorer le contact électrique entre le premier contact 40 et le deuxième empilement 20, celui-ci peut également comprendre une première couche métallique 42, reliant électriquement le deuxième empilement 20, intercalée entre eux. La première couche métallique 42 s'étend par exemple en partie sur le deuxième empilement 20 en recouvrant une partie verticale et une partie planaire dudit deuxième empilement 20. Dans un développement, la première couche métallique 42 est la couche conductrice 22 du deuxième empilement 20. La première couche métallique 42 pourrait aussi former l'une des colonnes d'adressage de la matrice, le via 41 étant un via de connexion de cette colonne, éventuellement déporté par rapport à l'ensemble 1.

De la même manière, le deuxième contact électrique 50 peut comprendre un deuxième via supérieur 51 s'étendant, par exemple, à la verticale du troisième empilement 30. Il peut également comprendre une deuxième couche métallique 52, reliant électriquement le troisième empilement 30. La deuxième couche métallique 52 peut également s'étendre sur le troisième empilement 30 en recouvrant une partie verticale et une partie planaire.

Comme déjà indiqué, la deuxième couche active 21 est reliée électriquement à la première électrode supérieure 121 de l'empilement planaire 10. Dans le mode de réalisation des [Fig.1a] et [Fig.1b], la deuxième couche active 21 est directement reliée électriquement à la première électrode supérieure 121. Plus précisément, elle vient directement en contact contre le premier flanc 1211 de cette électrode. Une surface de la deuxième couche active 21 est ainsi au contact de ce flanc 1211. En variante, une couche intermédiaire conductrice pourrait toutefois être intercalée entre la couche active 21 et le premier flanc 1211.

Ainsi, la deuxième couche active 21 présente une portion disposée entre la couche conductrice 22 du deuxième empilement 20 et la première électrode supérieure 121. Lorsque la deuxième couche active 21 est par exemple de type OxRAM ou CBRAM, l'application d'une différence de potentiel entre la couche conductrice 22 et la première électrode supérieure 121 lors d'une opération initiale de forming (première création d'un filament conducteur) entraîne la formation d'un canal de conduction, dans la deuxième couche active 21, au niveau d'une zone située en face du premier flanc 1211, de la première électrode supérieure 121. La position du canal de conduction est donc contrôlée (et, en l'occurrence, elle est elle aussi éloignée des bords - i.e. des extrémités - de la première couche active), permettant de réduire la variabilité du deuxième empilement vertical 20.

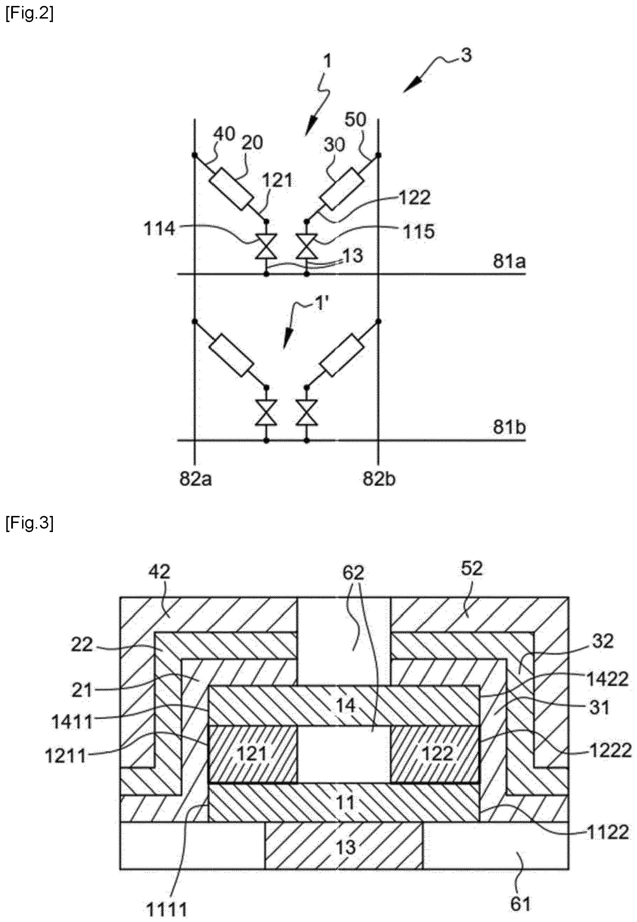

La deuxième couche active 21 peut comprendre une portion planaire, venant en quelque sorte recouvrir une partie de la première électrode supérieure 121. Afin de conserver la localisation du canal de conduction au niveau du premier flanc 1211 de la première électrode supérieure 121, l'ensemble 1 peut alors comprendre une couche isolante 141, 142. Il s'agit par exemple d'une couche en matériau diélectrique, tel que du nitrure de silicium, pour former notamment un masque dur. Une portion 141 au moins de la couche isolante est disposée entre ladite portion planaire de la deuxième couche active 21 et la première électrode supérieure 121, pour les isoler électriquement l'une de l'autre. La couche isolante 14 peut également s'étendre de manière continue sur les deux électrodes supérieures 121, 122 du premier empilement planaire 10, comme pour la variante du premier mode de réalisation représentée sur la [Fig.3].

La couche isolante 14 est par exemple délimitée par au moins une surface latérale. Lorsque la couche isolante 14 est continue et d'un seul tenant, elle est alors délimitée par une seule surface latérale 1411, 1422. La surface latérale de la couche isolante 14 comprend deux parties, opposées l'une à l'autre, appelées neuvième flanc 1411 et dixième flanc 1422 dans la suite, par exemple situés dans le prolongement des premier et deuxième flancs 1211, 1222. Lorsque la couche isolante 14 est divisée en deux portions distinctes 141, 142, elle est alors limitée par deux surfaces latérales, chacune délimitant une portion 141, 142. La première portion 141 de la couche isolante peut être située à l'aplomb de la première électrode supérieure 121, et peut comprendre, en plus du neuvième flanc 1411, une autre partie de sa surface latérale, appelée ici onzième flanc 1412. De même, la deuxième partie 142 peut être délimitée, en plus du dixième flanc 1422, par un autre flanc appelé douzième flanc 1421. Les onzième et douzième flancs 1412, 1421 sont par exemple situés respectivement dans le prolongement des septième et huitième flancs 1212, 1221, des première et deuxième électrodes supérieures 121, 122.

La [Fig.4] représente schématiquement le deuxième mode de réalisation de l'ensemble 1 de mémoires et de sélecteur. À la différence du mode de réalisation des [Fig.1a], [Fig.1b] et [Fig.3], la deuxième couche active 21 du deuxième empilement 20 n'est pas en contact avec la totalité du premier flanc 1211 de la première électrode supérieure 121.

**EP 4 454 443 B1**

En effet, dans ce deuxième mode de réalisation, l'ensemble 1 comprend en outre un espaceur 151, électriquement isolant, qui s'étend contre une partie de la surface latérale 1211, 1222 de la première électrode supérieure 121, et contre la surface latérale 1111, 1122 de la première couche active 11. Cet espaceur 151 s'étend notamment contre le troisième flanc 1111 de la première couche active 11 et contre une partie du premier flanc 1211 de la première électrode 121. Il permet de réduire la surface de la deuxième couche active 21 en contact avec le premier flanc 1211, permettant d'ajuster les propriétés électriques de la mémoire non-volatile s'établissant dans cette couche. En effet, la réduction de l'épaisseur D3 de la première électrode supérieur 121 peut présenter une limite, notamment technologique. Du fait de la présence de cet espaceur 151, seule une bande supérieure 12111 de la surface latérale de la première électrode 121, notamment du premier flanc 1211, est en contact avec la deuxième couche active 21. Par ailleurs, l'espaceur 151 protège le flanc, 1111 de la première couche active, notamment d'éventuelle contaminations, par exemple lors des étapes de fabrication de l'ensemble, telles que les opérations de formation des deuxième et troisième empilements 20, 30.

La première électrode supérieure 121 peut également être surmontée d'une couche conductrice supplémentaire 121', prolongeant verticalement l'électrode supérieure 121 (et son premier flanc 1211). De la sorte, le premier flanc 1211 présente une épaisseur totale D3 égale à l'épaisseur initiale D31 de la première électrode 121 plus une épaisseur supplémentaire D32 de la couche conductrice supplémentaire 121'. La bande supérieure 12111 du premier flanc 1211 laissée à nu par l'espaceur 151 peut ainsi être égale à l'épaisseur supplémentaire D32, voire moins.

Une partie de l'espaceur 151, ou éventuellement un autre espaceur similaire peut s'étendre partiellement entre, d'une part, le premier empilement et d'autre part, la troisième couche active 31. Il peut notamment s'étendre sur le deuxième flanc 1222 et le quatrième flanc 1122 en ne recouvrant que partiellement le deuxième flanc 1222, afin d'exposer une bande supérieure de la deuxième électrode supérieure, contre laquelle la troisième couche active 31 est en contact.

La [Fig.5] représente schématiquement, en coupe, le troisième mode de réalisation de l'ensemble 1. À la différence des modes de réalisation des [Fig.1a], [Fig.1b] et [Fig.4], la première couche active 11 est divisée en deux parties 116, 117. Elle comprend une première partie 116, et une deuxième partie 117 séparée de la première partie 116. La première partie 116 est reliée électriquement entre la première électrode supérieure 121 et l'électrode inférieure 13. La première partie 116 de la première couche active 11 s'étend par exemple à l'aplomb de la première électrode supérieure 121, dans le prolongement de cette dernière. Elle s'étend également, en partie, sur l'électrode inférieure 13 afin d'établir un contact électrique. La deuxième partie 117 de la couche active 11 s'étend également à l'aplomb de la deuxième électrode supérieure 122, dans le prolongement de cette dernière. De la même manière que la première partie 116, la deuxième partie 117 s'étend, en partie, sur l'électrode inférieure 13, afin d'établir un contact électrique.

Les première et deuxième parties 116, 117 sont avantageusement séparées par la première distance D1. La séparation physique entre les deux parties 116, 117 permet d'isoler électriquement les canaux de conduction pouvant s'établir entre chaque électrode supérieure 121, 122 et l'électrode inférieure 13. De la sorte les sélecteurs peuvent être opérés indépendamment l'un de l'autre, même lorsque la distance D1 entre les deux parties 116, 117 est inférieure à 60 nm, voire inférieure à 40 nm. Pour rappel, lorsque la première couche active comprend un matériau ovonique, les canaux de conduction peuvent présenter une dispersion latérale pouvant atteindre 40 nm, voire 60 nm. Les première et deuxième parties 116, 177 peuvent être au contact l'une de l'autre, en restant toutefois séparées l'une de l'autre par une barrière isolante, telle qu'une couche diélectrique.

La subdivision de la première couche active 11 en deux parties (116 et 117) résulte ici d'une gravure d'ensemble, d'un bloc, d'un empilement initial comprenant une couche active initiale, d'un seul tenant, et, par-dessus, une couche d'électrode supérieure, d'un seul tenant (ladite gravure séparant cette couche d'électrode pour obtenir les première et deuxième électrodes supérieures 121, 122).

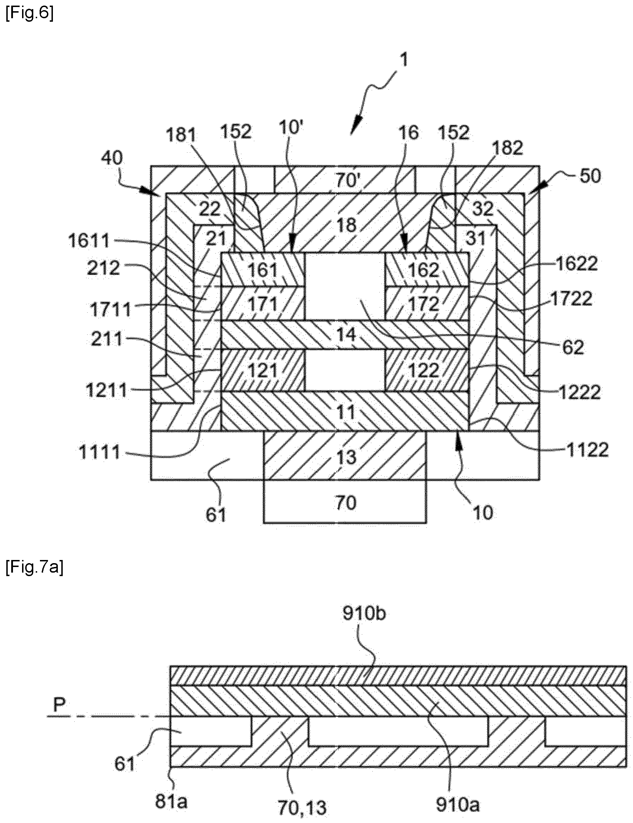

La [Fig.6] représente schématiquement le quatrième mode de réalisation de l'ensemble 1. À la différence des modes de réalisation des figures précédentes, l'ensemble 1 comprend ici un quatrième empilement sélecteur planaire 10'. Le premier empilement planaire 10 et le quatrième empilement planaire 10' sont orientés en tête-bêche. L'ensemble comprend également une couche isolante 14 s'étendant entre les premier et quatrième empilements planaires 10 et 10', de manière à les isoler électriquement l'un de l'autre.

Le quatrième empilement sélecteur 10' comprend une quatrième couche active 16, une troisième électrode 171 et une quatrième électrode 172. La quatrième couche active 16 est également une couche sélectrice. Dans cet exemple, la quatrième couche active 16 est divisée en une première partie 161 et une deuxième partie 162.

Les première et deuxième électrodes supérieures 121, 122 sont séparées des troisième et quatrième électrodes 171, 172 par la couche isolante 14. La quatrième couche active 16, ici ses première et deuxième parties 161, 162, s'étendent sur les troisième et quatrième électrodes 171, 172, contre et au-dessus de celles-ci. Les troisième et quatrième électrodes 171, 172 sont avantageusement distinctes et séparées par un isolant 62, tel qu'un matériau diélectrique. Elles n'ont pas de contact électrique direct entre elles et sont ainsi isolées électriquement l'une de l'autre.

Le premier empilement planaire 10 comprend une électrode inférieure 13, la première couche active 11 étant reliée à l'électrode inférieure 13. Le quatrième empilement planaire 10' peut également comprendre une cinquième électrode 18, s'étendant sur la quatrième couche active 16, au-dessus de celle-ci. La quatrième couche active 16 est ainsi reliée électriquement entre les troisième et quatrième électrodes 171, 172 d'une part, et la cinquième électrode 18 d'autre

**15**

part. La cinquième électrode 18 peut également être reliée électriquement à un via, appelé via supérieur 70', situé au-dessus du quatrième empilement planaire 10'. Le via supérieur 70' est disposé entre les premier et deuxième contacts électriques 40, 50, d'un point de vue latéral.

La troisième électrode 171 est également délimitée par une surface latérale comprenant au moins un flanc 1711, dit premier flanc additionnel, orienté verticalement. Le premier flanc additionnel 1711 est parallèle au premier flanc 1211 de la première électrode supérieure 121. Le premier flanc additionnel 1711 est préférentiellement aligné avec le premier flanc 1211 de la première électrode supérieure 121, situés dans le prolongement de celui-ci. En pratique, l'empilement global formé par le premier empilement planaire 10, la couche isolante 14 et le quatrième empilement planaire 10' qui vient la recouvrir, peut être délimité latéralement lors d'une même opération de gravure, globale, produisant, un même flanc global, d'ensemble, qui s'étend sur toute la hauteur de cet empilement global (et cela sur chaque côté, ou sur chaque face latérale de cet empilement global).

La deuxième couche active 21 du deuxième empilement vertical 20 s'étend verticalement sur toute une partie de la hauteur de cet empilement global (ici, sur toute la hauteur de cet empilement global, et même plus). Elle s'étend non seulement en vis-à-vis du premier flanc 1211, de la première électrode supérieure 121, mais aussi en vis-à-vis du premier flanc additionnel 1711, de la troisième électrode 171, parallèlement à ces flancs 1211, 1711. De cette manière, la deuxième couche active 21 du deuxième empilement vertical 20 peut comprendre deux canaux de conduction 211, 212 distincts (l'un, 211, situé en face du premier flanc 1211, et l'autre, 211, situé en face du premier flanc additionnel 1711), adressables indépendamment l'un de l'autre, permettant d'encoder chacun une information distincte. La seule couche active 21 permet ainsi de former deux « mémoires » distinctes.

De même que la deuxième couche active 21, la troisième couche active 31 s'étend verticalement sur toute une partie de la hauteur de l'empilement global en question (ici, sur toute la hauteur de cet empilement global, et même plus). Elle s'étend non seulement en vis-à-vis d'un deuxième flanc 1222 délimitant en partie la deuxième électrode supérieure 122, mais aussi en vis-à-vis d'un deuxième flanc additionnel 1722 de la quatrième électrode 172, parallèlement à ces flancs 1222, 1722.

La quatrième couche active 16 est divisée en une première partie 161 et une deuxième partie 162. Ladite première partie 161 s'étend sur la troisième électrode 171, par exemple dans le prolongement de cette dernière. Ladite deuxième partie 162 s'étend, de la même manière, sur la quatrième électrode 172.

La cinquième électrode 18 est isolée de chaque empilement verticaux 20, 30. Elle est par exemple isolée au moyen d'espaceurs isolants additionnels 152, s'étendant de part et d'autre de la cinquième électrode 18. La cinquième électrode 18 peut ainsi présenter une largeur plus petite que l'extension latérale de la quatrième couche active 16 (comme pour l'électrode inférieure 13 et la première couche active 11). La cinquième électrode 18 présente avantageusement une largeur telle qu'elle présente au moins une partie en vis-à-vis avec chacune des troisième et quatrième électrode 171, 173.

La [Fig.2] représente un schéma électrique équivalent de l'ensemble 1 tel que décrit en référence au [Fig.1a], [Fig.1b], [Fig.3], [Fig.4] et [Fig.5]. La [Fig.2] représente de manière plus large deux ensembles 1, 1' tels que décrits ci-dessus, appartenant à une matrice 3 de mémoires résistives. Les ensembles 1 et 1' sont préférentiellement identiques, connectés entre deux lignes d'adressage 81a, 81b et deux colonnes d'adressage 82a, 82b. L'ensemble 1 tel que décrit précédemment est notamment connecté entre une ligne 81a et deux colonnes 82a, 82b.

Le schéma électrique de l'ensemble 1 comprend deux circuits connectés à une ligne commune 81a. Un premier circuit comprend la première portion 114 de la première couche active 11, reliée en série avec le deuxième empilement vertical 20. Tous deux étant connectés entre l'électrode inférieure 13 et le premier contact électrique 40. L'électrode inférieure 13 est par exemple connectée à la ligne d'adresse 81a et le premier connecteur électrique est connecté à une première colonne d'adressage 82a. Un deuxième circuit comprend la deuxième portion 115 de la première couche active 11, reliée en série avec le troisième empilement 30. Tous deux étant connectés entre l'électrode inférieure 13 et le deuxième contact électrique 50. Le deuxième connecteur électrique est connecté à une deuxième colonne d'adressage 82b.

Le [Tableau1] ci-dessous présente un schéma de polarisation en tension des lignes et colonnes d'adressage 81a-b, 82a-b pour réaliser les opérations de programmation d'un état bassement résistif (SET), ou d'effacement (écriture d'un état hautement résistif, ou RESET) dans chacun des premier et deuxième empilements mémoires 20, 30. Il s'agit d'un schéma de polarisation de type « V/2 ». Il existe d'autres schémas de polarisation. Selon le schéma de polarisation « V/2 », la valeur de la tension U appliquée est choisie de sorte que :

- U soit supérieure à la tension de programmation d'un circuit 1S1R ; et

- U/2 soit inférieure à la tension de seuil de la première couche active 11.

[Tableau1]

| Opération | Empilement | 81a | 81b | 82a | 82b |
|---|---|---|---|---|---|
| Programmation | 20 | 0 | U/2 | U | U/2 |
| | 30 | | | U/2 | U |
| Effacement | 20 | U | | 0 | U/2 |
| | 30 | | | U/2 | 0 |

Selon un développement de l'invention, deux ensembles 1, tels que décrit par exemple aux [Fig.1a] et [Fig.1b], voisins l'un de l'autre, peuvent partager une même première couche active sélectrice, globale et commune aux deux ensembles. Les deux ensembles forment ainsi un ensemble global comprenant un première couche active globale, quatre électrodes supérieures et quatre empilements mémoires. La première couche active globale s'étend par exemple d'un seul tenant, d'un premier ensemble (c'est à dire un sous-ensemble de l'ensemble global) à un second ensemble. Les quatre électrodes supérieures s'étendent sur la première couche globale et relient chacune un empilement mémoire à une région de conduction de la couche sélectrice globale, c'est à dire à un sélecteur. La première couche active globale permet ainsi de former jusqu'à quatre sélecteurs distincts. L'ensemble global selon ce développement comprend donc quatre ensembles sélecteur/mémoire de type 1S1R en parallèles, adressables de manière indépendant et permettant de stocker quatre informations distinctes de manière non volatile. Autrement dit, l'ensemble globale est de type nSnR où n est au moins égal à quatre (plus généralement, au moins égal à deux).

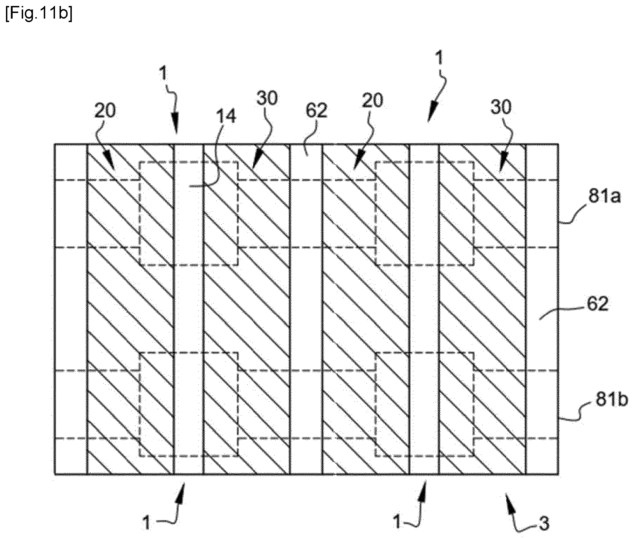

L'invention concerne également un procédé de fabrication d'un ensemble 1 de mémoires et de sélecteurs tel que décrit précédemment. Un mode de mise en œuvre dudit procédé est décrit en référence aux [Fig.7a] à [Fig.11b].

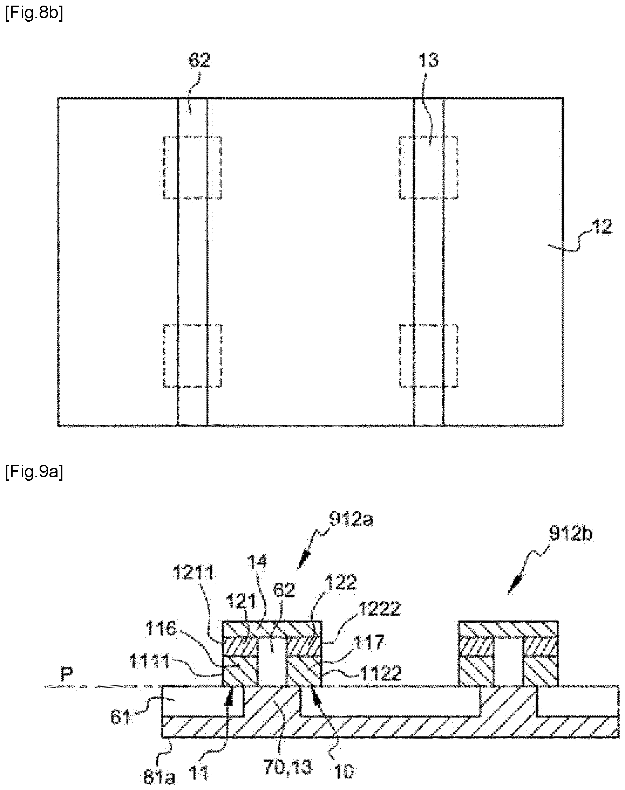

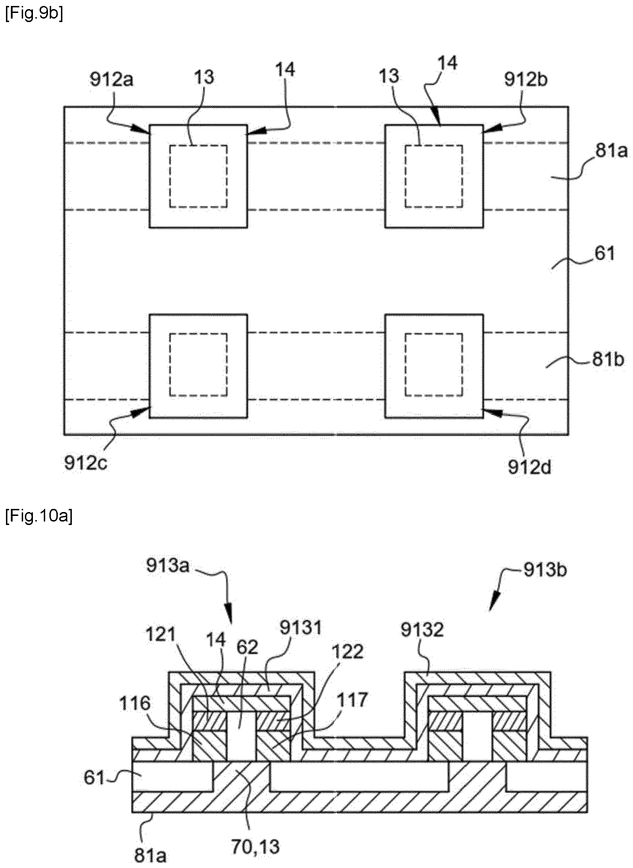

Les [Fig.9a] et [Fig.9b] représentent quatre premiers empilements intermédiaires 912a, 912b, 912c, 912d. Les quatre premiers empilements intermédiaires peuvent être réalisés simultanément, en vue de fabriquer une matrice 3 de mémoires résistives. La description ci-dessous vise un seul premier empilement intermédiaire 912a. Elle est toutefois transposable aux premiers empilements intermédiaires voisins 912b, 912c, 912d.

Le premier empilement intermédiaire 912a comprend, par exemple à partir de la surface d'une ligne d'adressage 81a, un via inférieur 70 et un premier empilement planaire 10 comprenant une électrode inférieure 13, une première couche active 11, une première électrode supérieure 121 et une deuxième électrode supérieure 122, s'étendant chacune sur la première couche active 11. Les première et deuxième électrodes 121, 122 sont surmontées d'une couche isolante 14. La première couche active 11 est une couche sélectrice. Elle est divisée en deux parties 116, 117 séparées l'une de l'autre. Le premier empilement intermédiaire 912a permet ainsi d'obtenir, à terme, un ensemble 1 selon le mode de réalisation de la [Fig.5].

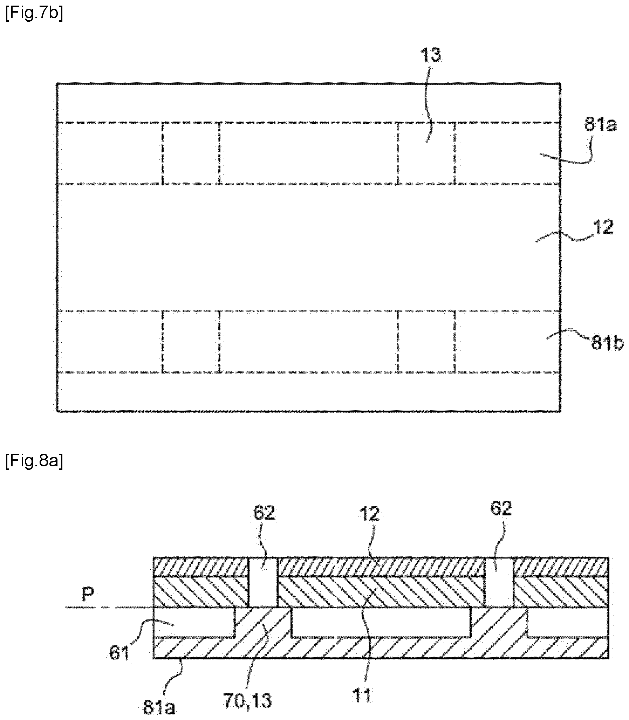

Pour obtenir ledit premier empilement intermédiaire 912a, le procédé de fabrication comprend dans un premier temps une étape de formation du premier empilement planaire 10. Cette étape peut comprendre une sous-étape de formation de l'électrode inférieure 13, s'étendant par exemple dans le prolongement du via inférieure 70. Le via inférieur 70 et l'électrode inférieure 13 ne sont pas différenciés sur les [Fig.7a] à [Fig.7b] pour ne pas surcharger les figures. L'électrode inférieure 13 peut être réalisée à base d'un alliage de TiN. Une couche diélectrique 62 enterre la ligne d'adressage 81a et arase l'électrode inférieure 13.

Chaque ligne d'adressage 81a, 81b et chaque via inférieur 70 peut être réalisé par la mise en œuvre d'un procédé damascène. Il s'agit par exemple du dépôt d'un matériau diélectrique, de la gravure de cavités destinées à former les lignes d'adressage 81a, 81b ou les vias inférieurs 70 et le remplissage desdites cavités par un revêtement ou « liner » en anglais, par exemple en nitrure de titane, et un matériau conducteur, par exemple du tungstène, suivi d'un polissage mécano-chimique (ou CMP). Les lignes d'adressage 81a, 81b sont enterrées dans la couche diélectrique 61. Chaque via inférieur 70 traverse la couche diélectrique 61.

Chaque électrode inférieure 13 est réalisée dans le prolongement de chaque via inférieur. Ladite couche diélectrique 61 et chaque électrode inférieur 13 sont mis à niveau par exemple au moyen d'une planarisation.

L'étape de formation comprend en outre une sous-étape de formation d'une première couche 910a, s'étendant parallèlement au plan P, tel qu'illustré par les [Fig.7a] et [Fig.7b]. Le plan P correspond par exemple à la surface de l'électrode inférieure 13 et de la couche diélectrique 61 sur laquelle la première couche 910a repose. La première couche 910a est destinée à former la première couche active 11. Elle est par exemple formée à base d'un alliage ovonique tel que le Ge-Se-Sb-N. De la sorte, le premier empilement planaire 10 assurera la fonction de sélecteur.

L'étape de formation du premier empilement 10 comprend également une sous-étape de formation d'une deuxième couche 910b, destinée à former les première et deuxième électrodes supérieures 121, 122. La deuxième couche 910b s'étend parallèlement au plan P, et repose sur la première couche 910a. La deuxième couche 910b est formée à partir d'un alliage conducteur, par exemple en TiN.

L'étape de formation comprend également une sous-étape de délimitation des première et deuxième couches 910a, 910b de manière à former la première couche active 11. La première couche active 11 est ainsi délimitée par des troisième et quatrième flancs 1111, 1122.

La sous-étape de délimitation est également réalisée de manière à obtenir la première électrode supérieure 121 et la deuxième électrode supérieure 122. La première électrode supérieure 121 est ainsi délimitée latéralement par au moins un premier flanc 1211 et la deuxième électrode supérieure 122 est délimitée par au moins un deuxième flanc 1222. En pratique, la première couche active 11 et les électrodes supérieures 121, 122 sont délimitées latéralement lors d'une même étape de gravure.

La séparation des première et deuxième électrode supérieures 121, 122 est également réalisée lors de la sous-étape de délimitation. La délimitation est par exemple réalisée par une première gravure, telle qu'illustrée par les [Fig.8a] et [Fig. 8b], formant une tranchée divisant la deuxième couche 910a en deux parties, destinée à former les électrodes supérieures 121, 122. Une deuxième gravure, telle qu'illustrée par les [Fig.9a] et [Fig.9b], délimite alors le pourtour du premier empilement planaire 10.

Après la première gravure, la tranchée peut être rempli avec un matériau diélectrique 62. Après dépôt, le matériau diélectrique 62 est avantageusement planarisé de manière à être à fleur de la surface supérieure des électrodes supérieures.

La première couche 910a peut également être divisée en deux parties lors de la première gravure. Ainsi, au terme de la deuxième gravure, la première couche active 11 comprend deux parties 116, 117 distinctes, dans le prolongement des première et deuxième électrodes supérieures 121, 122.

Le premier empilement intermédiaire 912a peut également comprendre une couche isolante 14, s'étendant sur les électrodes supérieures 121, 122. Auquel cas le procédé peut également comprendre une sous-étape de dépôt d'une couche isolante sur les premières et deuxièmes couches 910a, 910b de sorte que la délimitation de ces dernières permette également de délimiter la couche isolante 14. Le dépôt de la couche isolante peut intervenir entre les première et deuxième gravures décrites précédemment. De la sorte, la couche isolante 14 s'étend de manière continue de la première électrode supérieure 121 à la deuxième électrode supérieure 122.

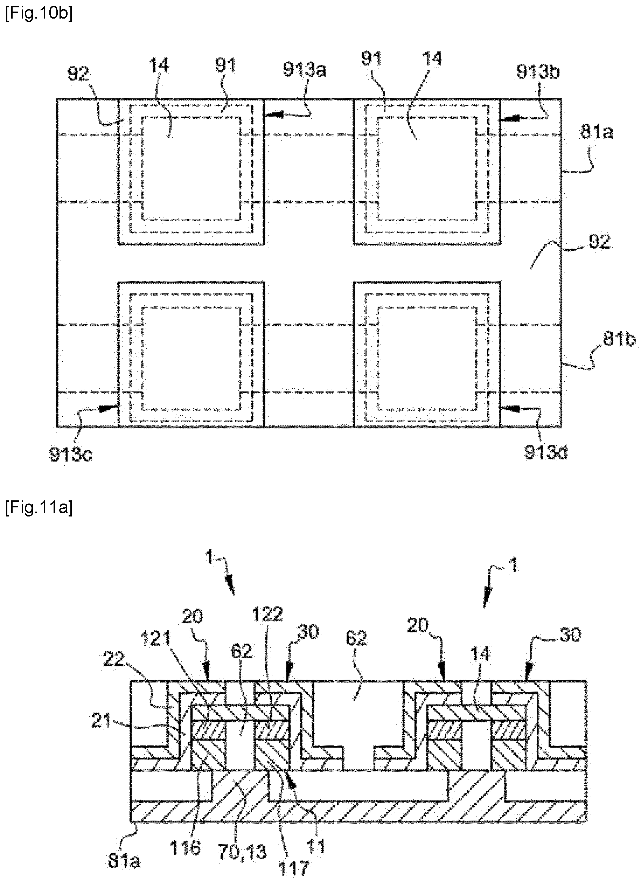

Les [Fig.10a] et [Fig.10b] représentent un deuxième empilement intermédiaire 913a comprenant une couche active globale 9131, recouvrant le premier empilement planaire 10 et la surface de la couche diélectrique 62 non-recouverte par les empilements planaire 10. La couche active globale 9131 est destinée à former les deuxième et troisième couches actives 21, 31 des premier et deuxième empilements verticaux 20, 30.

Le deuxième empilement intermédiaire 913a peut également comprendre une couche conductrice globale 9132 s'étend sur la couche active globale 9131, destinée à former les couches conductrices 22, 32 des deuxième et troisième empilements 20, 30. Il peut également comprendre une couche conductrice additionnelle, destinée à former une partie au moins des premier et deuxième contacts électrique 40, 50. Ici, la couche conductrice additionnelle peut être destinée, après gravure, à former des colonnes d'adressage de la matrice.

La formation des deuxième et troisième empilements 20, 30 comprend dans un premier temps une sous-étape de dépôt de la couche active globale 9131 sur le premier empilement planaire 10 et sur la couche diélectrique 61. Une première partie au moins de la couche active globale 9131 s'étend parallèlement au premier et deuxième flancs 1211, 1222 des électrodes supérieures 121. Elle s'étend notamment au moins en partie en vis-à-vis du premier flanc 1211 de la première électrode supérieure 121 et du deuxième flanc 1222 de la deuxième électrode supérieure 122. Le dépôt de la couche active globale 9131 est réalisé de manière conforme, par exemple de manière à présenter une épaisseur sensiblement constante en tout point. Par sensiblement constante, on entend à 20% près au moins, par exemple à 10% ou même 5% près, voire mieux. Ce dépôt conforme est réalisé par exemple par « ALD » (pour « Atomic Layer Dépositions » en anglais).

Le procédé peut en outre comprendre une sous-étape de dépôt de la couche conductrice 9132, par exemple par dépôt conforme, de sorte qu'elle s'étende sur la couche active globale 9131. Le procédé peut également comprendre une sous-étape de dépôt de la couche conductrice additionnelle, par exemple également par dépôt conforme, de sorte qu'elle s'étende sur la couche conductrice 9132.

Les [Fig.11a] et [Fig.11b] représentent un ensemble 1, différent du deuxième empilement intermédiaire 913a des [Fig.10a] et [Fig.10b] en ce qu'il comprend des deuxième et troisième empilements 20, 30, disposés de part et d'autre du premier empilement planaire 10.

Pour obtenir les deuxième et troisième empilements mémoire 20, 30, le procédé comprend la gravure de la couche active globale 9131 de manière à la séparer en une deuxième couche active 21 et une troisième couche active 31. La gravure est réalisée de sorte qu'une première partie au moins de la deuxième couche active 21 s'étende parallèlement au premier flanc 1211 de la première électrode supérieure 121, en vis-à-vis de ce premier flanc 1211 et de sorte qu'une deuxième partie au moins de la troisième couche active 31 s'étende parallèlement au deuxième flanc 1222 de la deuxième électrode supérieure de sélecteur 122, en vis-à-vis de ce deuxième flanc 1222.

La gravure peut être stoppée avant d'atteindre la couche isolante 14. Toutefois, selon un développement, la couche active globale 9131 et le premier empilement planaire 10 pourraient être gravé en une seule fois, divisant ainsi chaque couche en deux parties distinctes. Quoiqu'il en soit, la gravure est stoppée avant d'atteindre l'électrode inférieure 13.

L'étape de gravure 922 peut également graver dans le même temps la couche conductrice 9132 en deux parties de sorte qu'elles forment respectivement les couches conductrices 22, 32, s'étendant respectivement sur les deuxième et troisième couches actives 21, 31. Pour que l'ensemble formé soit fonctionnel, il est nécessaire que l'étape de gravure divise au moins la couche 9132.

La formation des contacts électrique 42, 52 est par exemple réalisée au même moment que l'étape de gravure de la couche conductrice 9132. Elle permet ainsi de séparer électriquement les contact électriques 42, 52 les uns des autres.

L'étape de gravure peut également permettre de séparer électriquement les deuxièmes empilements intermédiaires 913b, 913c, 913d voisins en séparant les couches 9131, 9132 déposées sur chaque premier empilement planaire 10.

Les [Fig.11a] et [Fig.11b] représentent des ensembles 1 de mémoire résistive 1 formant une matrice 3 de mémoires résistives. Chacun des deuxième et troisième empilements vertical 20, 30 sont reliés à des colonnes d'adressage distinctes. Afin de connecter chaque empilement vertical 20, 30, le procédé peut comprendre la formation de colonne d'adressage. Pour cela, les ensembles 1 sont enterrés sous une couche complémentaire de diélectrique 62. La couche complémentaire de diélectrique 62 est mise à niveau de chaque contact électrique par planarisation. Ensuite les colonnes d'adressage sont formées, par exemple par la mise en œuvre d'un procédé damascène.

**Revendications**

1.  Ensemble (1) comprenant au moins deux mémoires résistives non volatiles disposées électriquement en parallèle entre elles et étant chacune électriquement connectées en série à une couche sélectrice formant respectivement au moins deux sélecteurs, chacun dédié à l'une des mémoires, l'ensemble comportant :

    - un premier empilement (10) planaire, comprenant :

        - une première couche active (11) qui s'étend parallèlement à un plan (P) horizontal donné, la première couche active (11) étant ladite couche sélectrice ; et
        - une première électrode supérieure (121) et une deuxième électrode supérieure (122) qui s'étendent toutes deux sur la première couche active (11) et qui sont isolées électriquement l'une de l'autre, la première électrode supérieure (121) étant délimitée latéralement par une surface latérale (1211, 1212), la deuxième électrode supérieure (122) étant délimitée latéralement par une autre surface latérale (1221, 1222), une couche isolante (62) s'étendant entre une partie de la surface latérale (1212) de la première électrode supérieure (121) et une partie de la surface latérale (1221) de la deuxième électrode supérieure (122) pour isoler électriquement la première électrode supérieure (121) de la deuxième électrode supérieure (122) ;

        - un deuxième empilement (20), qui s'étend de manière oblique ou perpendiculaire par rapport audit plan (P), comprenant une deuxième couche active (21), une partie au moins de la deuxième couche active (21) s'étendant en vis-à-vis d'une autre partie (1211) de la surface latérale de la première électrode supérieure (121), la deuxième couche active (21) étant en contact électrique avec la première électrode supérieure (121), la deuxième couche active (21) étant une couche mémoire résistive non-volatile, ledit deuxième empilement comportant une première couche conductrice (22) s'étendant sur la deuxième couche active (21), une partie au moins de la couche conductrice (22) s'étendant également en vis-à-vis de l'autre partie (1211) de la surface latérale de la première électrode supérieure (121) ;
        - un troisième empilement (30), qui s'étend de manière oblique ou perpendiculaire par rapport audit plan (P), comprenant une troisième couche active (31), une partie au moins de la troisième couche active (31) s'étendant en vis-à-vis d'une autre partie (1222) de la surface latérale de la deuxième électrode supérieure (122), la troisième couche active (31) étant en contact électrique avec la deuxième électrode supérieure (122) la troisième couche active (21) étant une couche mémoire résistive non-volatile, ledit troisième empilement comportant une deuxième couche conductrice (32) s'étendant sur la troisième couche active (31), une partie au moins de la couche conductrice (32) s'étendant également en vis-à-vis de l'autre partie (1222) de la surface latérale de la deuxième électrode supérieure (122) ;
        - les deuxième et troisième couches actives (21, 31) étant disjointes, sans contact électrique direct entre elles.

2.  Ensemble (1) selon la revendication précédente,

    - comprenant une électrode inférieure (13), qui s'étend sous la première couche active (11), parallèlement à celle-ci, et qui est en contact électrique avec une face inférieure (115) de la première couche active (11), dans lequel

- une partie au moins de la première électrode supérieure (121) est située à l'aplomb de l'électrode inférieure (13), en se superposant à l'électrode inférieure (13), en projection selon une direction perpendiculaire audit plan (P), et dans lequel

- une partie au moins de la deuxième électrode supérieure (122) est située à l'aplomb de l'électrode inférieure (13), en se superposant à l'électrode inférieure (13), en projection selon une direction perpendiculaire audit plan (P).

3. Ensemble (1) selon la revendication précédente, dans lequel au moins une des électrodes supérieures (121, 122) se superpose uniquement en partie à l'électrode inférieure (13).

4. Ensemble (1) selon la revendication 2 ou 3, dans lequel :

- les première et deuxième électrodes supérieures (121, 122) sont séparées l'une de l'autre, selon une direction (X) horizontale donnée, par un écart (D1) donné, et dans lequel

- selon ladite direction (X), la première électrode supérieure (121) se superpose à l'électrode inférieure (13) sur une distance qui est inférieure audit écart (D1).

5. Ensemble (1) selon l'une des revendications 2 à 4, dans lequel la première couche active (11) s'étend latéralement au-delà de l'électrode inférieure (13), en débordant sur une couche diélectrique (61) qui entoure l'électrode inférieure (13).

6. Ensemble (1) selon l'une des revendications précédentes, dans lequel :

- la première couche active (11) est délimitée latéralement par une surface latérale (1111, 1122), et

- l'ensemble (1) comprend en outre un espaceur (151) électriquement isolant qui s'étend au moins contre la surface latérale (1111, 1122) de la première couche active (11), en recouvrant au moins en partie cette surface latérale (1111, 1122).

7. Ensemble (1) selon la revendication précédente, dans lequel l'espaceur (151) recouvre aussi, en partie uniquement, la surface latérale (1211, 1222) d'au moins une des première et deuxième électrodes supérieures (121, 122).

8. Ensemble (1) selon l'une des revendications précédentes, dans lequel les première et deuxième électrodes supérieures (121, 122) sont au contact direct de la première couche active (11).

9. Ensemble (1) selon l'une des revendications précédentes, dans lequel le premier empilement planaire (10) comprend une couche isolante (14) qui s'étend au-dessus des première et deuxième électrodes supérieures (121, 122).

10. Ensemble (1) selon la revendication précédente, comprenant un quatrième empilement (10'), planaire, disposé sur la couche isolante (14), le quatrième empilement comprenant :

- une quatrième couche active (16) qui s'étend parallèlement audit plan (P), la quatrième couche active (16) étant une couche sélectrice ;

- une troisième et une quatrième électrodes (171, 172) qui s'étendent parallèlement audit plan (P), entre la quatrième couche active (16) et la couche isolante (14), et qui sont isolées électriquement l'une de l'autre, la troisième électrode (171) étant délimitée latéralement par une surface latérale (1711), la quatrième électrode (172) étant délimitée latéralement par une autre surface latérale (1722), une couche isolante s'étendant entre une partie de la surface latérale de la troisième électrode (171) et une partie de la surface latérale de la quatrième électrode (172) pour isoler électriquement la troisième électrode de la quatrième électrode ;

dans lequel la deuxième couche active (21) se prolonge au-delà de la surface latérale (1211) de la première électrode supérieure (121), en s'étendant le long d'une partie (1711) de la surface latérale de la troisième électrode (171),

et dans lequel la troisième couche active (31) se prolonge au-delà de la surface latérale (1222) de la deuxième électrode supérieure (122) en s'étendant le long d'une partie (1722) de la surface latérale de la quatrième électrode (172).

11. Ensemble (1) selon la revendication précédente, dans lequel le quatrième empilement comprend :

- une cinquième électrode (18), qui s'étend au-dessus de la quatrième couche active (16), en contact électrique avec la quatrième couche active, et

- un troisième espaceur (152) électriquement isolant qui recouvre une surface latérale (181, 182) de la cinquième électrode (18).

12. Ensemble (1) selon l'une des revendications 1 à 11, dans lequel la première couche active (11), commune aux deuxième et troisième empilements (20, 30), est continue, d'un seul tenant.

13. Ensemble (1) selon l'une des revendications 1 à 11, dans lequel la première couche active (11) est divisée en une première partie (116) et une deuxième partie (117) disjointes, la première partie (116) de la couche active (11) s'étendant sous la première électrode supérieure (121), la deuxième partie (117) de la couche active (11) s'étendant sous la deuxième électrode supérieure (122).

14. Matrice (3) de mémoires résistives comprenant une pluralité d'ensembles (1) selon l'une des revendications précédentes, dans laquelle, pour chaque ensemble (1, 1') :

   - le premier empilement planaire (10) de l'ensemble (1) est relié électriquement à une ligne d'adressage (81a) de la matrice,
   - les deuxième et troisième empilements verticaux (20, 30) de l'ensemble (1) sont reliés électriquement, respectivement, à deux colonnes d'adressage (82a, 82b) de la matrice, les deux colonnes d'adressage étant distinctes.

15. Procédé de fabrication d'un ensemble (1) comprenant au moins deux mémoires résistives non volatiles disposées électriquement en parallèle entre elles et étant chacune électriquement connectées en série, à une couche sélectrice formant respectivement au moins deux sélecteurs, chacun dédié à l'une des mémoires, le procédé comprenant les étapes suivantes :

   - formation d'un premier empilement planaire (10) comprenant :

      - un dépôt d'une première couche active (11) qui s'étend parallèlement à un plan (P) horizontal donné, la première couche active étant ladite couche sélectrice (11) ; et
      - un dépôt d'une première électrode supérieure (121) et d'une deuxième électrode supérieure (122) qui s'étendent toutes deux sur la première couche active (11) et qui sont isolées électriquement l'une de l'autre, la première électrode supérieure (121) étant délimitée latéralement par une surface latérale (1211, 1212), la deuxième électrode supérieure (122) étant délimitée latéralement par une autre surface latérale (1221, 1222), une couche isolante (62) s'étendant entre une partie de la surface latérale (1212) de la première électrode supérieure (121) et une partie de la surface latérale (1221) de la deuxième électrode supérieure (122) pour isoler électriquement la première électrode supérieure (121) de la deuxième électrode supérieure (122) ;

   - formation d'un deuxième empilement (20), qui s'étend de manière oblique ou perpendiculaire par rapport audit plan (P), comprenant une deuxième couche active (21), une partie au moins de la deuxième couche active (21) s'étendant en vis-à-vis d'une autre partie (1211) de la surface latérale de la première électrode supérieure (121), la deuxième couche active (21) étant en contact électrique avec la première électrode supérieure (121), la deuxième couche active (21) étant une couche mémoire résistive non-volatile, ledit deuxième empilement comportant une première couche conductrice (22) s'étendant sur la deuxième couche active (21), une partie au moins de la couche conductrice (22) s'étendant également en vis-à-vis de l'autre partie (1211) de la surface latérale de la première électrode supérieure (121) ;
   - formation d'un troisième empilement (30), qui s'étend de manière oblique ou perpendiculaire par rapport audit plan (P), comprenant une troisième couche active (31), une partie au moins de la troisième couche active (31) s'étendant en vis-à-vis d'une autre partie (1222) de la surface latérale de la deuxième électrode supérieure (122), la troisième couche active (32) étant en contact électrique avec la deuxième électrode supérieure (122), la troisième couche active (31) étant une autre couche mémoire résistive non-volatile, ledit troisième empilement comportant une deuxième couche conductrice (32) s'étendant sur la troisième couche active (31), une partie au moins de la couche conductrice (32) s'étendant également en vis-à-vis de l'autre partie (1222) de la surface latérale de la deuxième électrode supérieure (122).

16. Procédé selon la revendication précédente, dans lequel les étapes de formation des deuxième et troisième empilements sont réalisées en exécutant les étapes suivantes :

- dépôt conforme d'une couche active globale (9131), une première partie de la couche active globale (9131) s'étendant en vis-à-vis de la surface latérale (1211) de la première électrode supérieure (121), la première partie de la couche active globale (9131) étant en contact électrique avec la première électrode supérieure (121), une deuxième partie de la couche active globale (9131) s'étendant en vis-à-vis de la surface latérale (1222) de la deuxième électrode supérieure (122), la deuxième partie de la couche active globale (9131) étant en contact électrique avec la deuxième électrode supérieure (121) ;
- séparer la couche active globale (9131) en au moins ladite deuxième couche active (21) et ladite une troisième couche active (31), disjointes.

**Patentansprüche**

1. Array (1) mit mindestens zwei nichtflüchtigen resistiven Speichern, die elektrisch parallel zueinander geschaltet und elektrisch jeweils in Reihe mit einer Selektorschicht verbunden sind, die jeweils mindestens zwei Selektoren bilden, von denen jeder einem der Speicher zugeordnet ist, wobei das Array umfasst:

   - einen ersten planaren Stapel (10), umfassend:

      ∘ eine erste aktive Schicht (11), die sich parallel zu einer gegebenen horizontalen Ebene (P) erstreckt, wobei die erste aktive Schicht (11) die Selektorschicht ist; und
      ∘ eine erste obere Elektrode (121) und eine zweite obere Elektrode (122), die sich beide über der ersten aktiven Schicht (11) erstrecken und elektrisch voneinander isoliert sind, wobei die erste obere Elektrode (121) seitlich durch eine Seitenfläche (1211, 1212) begrenzt ist und die zweite obere Elektrode (122) seitlich durch eine weitere Seitenfläche (1221, 1222) begrenzt ist, wobei sich eine Isolierschicht (62) zwischen einem Teil der Seitenfläche (1212) der ersten oberen Elektrode (121) und einem Teil der Seitenfläche (1221) der zweiten oberen Elektrode (122) erstreckt, um die erste obere Elektrode (121) von der zweiten oberen Elektrode (122) zu isolieren;

   - einen zweiten Stapel (20), der sich schräg oder senkrecht zu der Ebene (P) erstreckt und eine zweite aktive Schicht (21) umfasst, wobei sich mindestens ein Teil der zweiten aktiven Schicht (21) gegenüber einem anderen Teil (1211) der Seitenfläche der ersten oberen Elektrode (121) erstreckt, wobei die zweite aktive Schicht (21) in elektrischem Kontakt mit der ersten oberen Elektrode (121) steht, wobei die zweite aktive Schicht (21) eine nichtflüchtige resistive Speicherschicht ist, wobei der zweite Stapel eine erste leitfähige Schicht (22) umfasst, die sich über die zweite aktive Schicht (21) erstreckt, wobei sich ein Teil der leitenden Schicht (22) ebenfalls gegenüber dem anderen Teil (1211) der Seitenfläche der ersten oberen Elektrode (121) erstreckt;
   - einen dritten Stapel (30), der sich schräg oder senkrecht zu der Ebene (P) erstreckt und eine dritte aktive Schicht (31) umfasst, wobei sich mindestens ein Teil der dritten aktiven Schicht (31) gegenüber einem anderen Teil (1222) der Seitenfläche der zweiten oberen Elektrode (122) erstreckt, wobei die dritte aktive Schicht (31) in elektrischem Kontakt mit der zweiten oberen Elektrode (122) steht, wobei die dritte aktive Schicht (21) eine nichtflüchtige resistive Speicherschicht ist und der dritte Stapel eine zweite leitende Schicht (32) umfasst, die sich über der dritten aktiven Schicht (31) erstreckt, wobei sich mindestens ein Teil der leitenden Schicht (32) ebenfalls gegenüber dem anderen Teil (1222) der Seitenfläche der zweiten oberen Elektrode (122) erstreckt;
   - wobei die zweite und dritte aktive Schicht (21, 31) voneinander getrennt sind und keinen direkten elektrischen Kontakt miteinander haben.

2. Array (1) gemäß dem vorhergehenden Anspruch,

   - mit einer unteren Elektrode (13), die sich unter der ersten aktiven Schicht (11) parallel zu dieser erstreckt und in elektrischem Kontakt mit einer Unterseite (115) der ersten aktiven Schicht (11) steht, wobei
   - mindestens ein Teil der ersten oberen Elektrode (121) senkrecht über der unteren Elektrode (13) angeordnet ist und die untere Elektrode (13) in einer zu der Ebene (P) senkrechten Richtung überlagert, und wobei
   - mindestens ein Teil der zweiten oberen Elektrode (122) senkrecht über der unteren Elektrode (13) angeordnet ist und die untere Elektrode (13) in einer zu der Ebene (P) senkrechten Richtung überlagert.

3. Array (1) nach dem vorhergehenden Anspruch, in dem mindestens eine der oberen Elektroden (121, 122) die untere Elektrode (13) nur teilweise überlagert.

4. Array (1) nach Anspruch 2 oder 3, in dem:

- die erste und die zweite obere Elektrode (121, 122) in einer gegebenen horizontalen Richtung (X) um einen gegebenen Abstand (D1) voneinander getrennt sind, und in dem
- in dieser Richtung (X) die erste obere Elektrode (121) die untere Elektrode (13) über eine Entfernung überlagert, die kleiner ist als der gegebene Abstand (D1).

5. Array (1) nach einem der Ansprüche 2 bis 4, in dem sich die erste aktive Schicht (11) seitlich über die untere Elektrode (13) hinaus erstreckt und über eine dielektrische Schicht (61) hinausragt, die die untere Elektrode (13) umgibt.

6. Array (1) nach einem der vorhergehenden Ansprüche, in dem:

   - die erste aktive Schicht (11) seitlich durch eine Seitenfläche (1111, 1122) begrenzt ist, und
   - das Array (1) ferner einen elektrisch isolierenden Abstandshalter (151) umfasst, der sich zumindest an der Seitenfläche (1111, 1122) der ersten aktiven Schicht (11) erstreckt und diese Seitenfläche (1111, 1122) zumindest teilweise bedeckt.

7. Array (1) nach dem vorhergehenden Anspruch, in dem der Abstandshalter (151) teilweise auch die Seitenfläche (1211, 1222) mindestens einer der ersten und zweiten oberen Elektroden (121, 122) bedeckt.

8. Array (1) nach einem der vorhergehenden Ansprüche, in dem die erste und die zweite obere Elektrode (121, 122) in direktem Kontakt mit der ersten aktiven Schicht (11) stehen.

9. Array (1) nach einem der vorhergehenden Ansprüche, in dem der erste planare Stapel (10) eine Isolierschicht (14) umfasst, die sich über die erste und zweite obere Elektrode (121, 122) erstreckt.

10. Array (1) gemäß dem vorhergehenden Anspruch, einen vierten planaren Stapel (10') umfassend, der auf der Isolierschicht (14) angeordnet ist, wobei der vierte Stapel umfasst:

    - eine vierte aktive Schicht (16), die sich parallel zu der Ebene (P) erstreckt, wobei die vierte aktive Schicht (16) eine selektive Schicht ist;
    - eine dritte und eine vierte Elektrode (171, 172), die sich parallel zu der Ebene (P) zwischen der vierten aktiven Schicht (16) und der Isolierschicht (14) erstrecken und elektrisch voneinander isoliert sind, wobei die dritte Elektrode (171) seitlich durch eine Seitenfläche (1711) begrenzt ist und die vierte Elektrode (172) seitlich durch eine weitere Seitenfläche (1722) begrenzt ist, wobei sich eine Isolierschicht zwischen einem Teil der Seitenfläche der dritten Elektrode (171) und einem Teil der Seitenfläche der vierten Elektrode (172) erstreckt, um die dritte Elektrode elektrisch von der vierten Elektrode zu isolieren;
    wobei sich die zweite aktive Schicht (21) über die Seitenfläche (1211) der ersten oberen Elektrode (121) hinaus erstreckt, indem sie sich entlang eines Abschnitts (1711) der Seitenfläche der dritten Elektrode (171) erstreckt, und wobei sich die dritte aktive Schicht (31) über die Seitenfläche (1222) der zweiten oberen Elektrode (122) hinaus erstreckt, indem sie sich entlang eines Abschnitts (1722) der Seitenfläche der vierten Elektrode (172) erstreckt.

11. Array (1) nach dem vorhergehenden Anspruch, in dem der vierte Stapel umfasst:

    - eine fünfte Elektrode (18), die sich über die vierte aktive Schicht (16) erstreckt und in elektrischem Kontakt mit der vierten aktiven Schicht steht, und
    - einen dritten elektrisch isolierenden Abstandshalter (152), der eine Seitenfläche (181, 182) der fünften Elektrode (18) bedeckt.

12. Array (1) nach einem der Ansprüche 1 bis 11, in dem die erste aktive Schicht (11), die dem zweiten und dritten Stapel (20, 30) gemeinsam ist, durchgehend und einstückig ist.

13. Array (1) gemäß einem der Ansprüche 1 bis 11, in dem die erste aktive Schicht (11) in einen ersten Teil (116) und einen zweiten Teil (117) unterteilt ist, die voneinander getrennt sind, wobei sich der erste Teil (116) der aktiven Schicht (11) unter der ersten oberen Elektrode (121) erstreckt und der zweite Teil (117) der aktiven Schicht (11) sich unter der zweiten oberen Elektrode (122) erstreckt.

14. Matrix (3) von resistiven Speichern, die eine Vielzahl von Arrays (1) gemäß einem der vorstehenden Ansprüche umfasst, wobei für jedes Array (1, 1') gilt:

- der erste planare Stapel (10) des Arrays (1) ist elektrisch mit einer Adressierungzeile (81a) der Matrix verbunden,
- der zweite und der dritte vertikale Stapel (20, 30) des Arrays (1) sind elektrisch jeweils mit zwei Adressierungsspalten (82a, 82b) der Matrix verbunden, wobei die beiden Adressierungsspalten voneinander getrennt sind.

15. Verfahren zur Herstellung eines Arrays (1) mit mindestens zwei nichtflüchtigen resistiven Speichern, die elektrisch parallel zueinander angeordnet und elektrisch jeweils in Reihe mit einer Selektorschicht verbunden sind, die mindestens zwei Selektoren bilden, von denen jeder einem der Speicher zugeordnet ist, wobei das Verfahren die folgenden Schritte umfasst:

- Bilden eines ersten planaren Stapels (10), umfassend:

  ○ Aufbringen einer ersten aktiven Schicht (11), die sich parallel zu einer gegebenen horizontalen Ebene (P) erstreckt, wobei die erste aktive Schicht die selektive Schicht (11) ist; und
  ○ Aufbringen einer ersten oberen Elektrode (121) und einer zweiten oberen Elektrode (122), die sich beide über die erste aktive Schicht (11) erstrecken und elektrisch voneinander isoliert sind, wobei die erste obere Elektrode (121) seitlich durch eine Seitenfläche (1211, 1212) begrenzt ist und die zweite obere Elektrode (122) seitlich durch eine weitere Seitenfläche (1221, 1222) begrenzt ist, wobei sich eine Isolierschicht (62) zwischen einem Teil der Seitenfläche (1212) der ersten oberen Elektrode (121) und einem Teil der Seitenfläche (1221) der zweiten oberen Elektrode (122) erstreckt, um die erste obere Elektrode (121) von der zweiten oberen Elektrode (122) zu isolieren;

- Bilden eines zweiten Stapels (20), der sich schräg oder senkrecht zu der Ebene (P) erstreckt und eine zweite aktive Schicht (21) umfasst, wobei sich mindestens ein Teil der zweiten aktiven Schicht (21) gegenüber einem anderen Teil (1211) der Seitenfläche der ersten oberen Elektrode (121) erstreckt, wobei die zweite aktive Schicht (21) in elektrischem Kontakt mit der ersten oberen Elektrode (121) steht und eine nichtflüchtige resistive Speicherschicht ist, wobei der zweite Stapel eine erste leitende Schicht (22) umfasst, die sich über die zweite aktive Schicht (21) erstreckt, wobei sich mindestens ein Teil der leitenden Schicht (22) ebenfalls gegenüber dem anderen Teil (1211) der Seitenfläche der ersten oberen Elektrode (121) erstreckt;
- Bilden eines dritten Stapels (30), der sich schräg oder senkrecht zu der Ebene (P) erstreckt und eine dritte aktive Schicht (31) umfasst, wobei sich mindestens ein Teil der dritten aktiven Schicht (31) gegenüber einem anderen Teil (1222) der Seitenfläche der zweiten oberen Elektrode (122) erstreckt, wobei die dritte aktive Schicht (32) in elektrischem Kontakt mit der zweiten oberen Elektrode (122) steht und eine weitere nichtflüchtige resistive Speicherschicht ist, wobei der dritte Stapel eine zweite leitfähige Schicht (32) umfasst, die sich über die dritte aktive Schicht (31) erstreckt, wobei sich mindestens ein Teil der leitenden Schicht (32) ebenfalls gegenüber dem anderen Teil (1222) der Seitenfläche der zweiten oberen Elektrode (122) erstreckt.

16. Verfahren nach dem vorhergehenden Anspruch, bei dem die Schritte zum Bilden des zweiten und dritten Stapels durch Ausführen der folgenden Schritte durchgeführt werden:

- konformes Aufbringen einer gesamten aktiven Schicht (9131), wobei sich ein erster Teil der gesamten aktiven Schicht (9131) gegenüber der Seitenfläche (1211) der ersten oberen Elektrode (121) erstreckt, wobei der erste Teil der gesamten aktiven Schicht (9131) in elektrischem Kontakt mit der ersten oberen Elektrode (121) steht, ein zweiter Teil der gesamten aktiven Schicht (9131) sich gegenüber der Seitenfläche (1222) der zweiten oberen Elektrode (122) erstreckt, wobei der zweite Teil der gesamten aktiven Schicht (9131) in elektrischem Kontakt mit der zweiten oberen Elektrode (121) steht;
- Trennen der gesamten aktiven Schicht (9131) in mindestens die zweite aktive Schicht (21) und die eine dritte aktive Schicht (31), die voneinander getrennt sind.

## Claims

1. An assembly (1) comprising at least two non-volatile resistive memories electrically disposed in parallel with each other and each being electrically connected in series to a selective layer respectively forming at least two selectors, each dedicated to one of the memories, the assembly including:

- a first planar stack (10), comprising:

- a first active layer (11) which extends in parallel to a given horizontal plane (P), the first active layer (11) being said selective layer; and
- a first upper electrode (121) and a second upper electrode (122) which both extend on the first active layer (11) and which are electrically insulated from each other, the first upper electrode (121) being laterally delimited by a side surface (1211, 1212), the second upper electrode (122) being laterally delimited by another side surface (1221, 1222), an insulating layer (62) extending between a part of the side surface (1212) of the first upper electrode (121) and a part of the side surface (1221) of the second upper electrode (122) to electrically insulate the first upper electrode (121) from the second upper electrode (122);

- a second stack (20), which extends obliquely or perpendicularly to said plane (P), comprising a second active layer (21), at least a part of the second active layer (21) extending opposite another part (1211) of the side surface of the first upper electrode (121), the second active layer (21) being in electrical contact with the first upper electrode (121), the second active layer (21) being a non-volatile resistive memory layer, said second stack comprising a first conductive layer (22) extending on the second active layer (21), at least a part of the conductive layer (22) also extending opposite the other part (1211) of the side surface of the first upper electrode (121);
- a third stack (30), which extends obliquely or perpendicularly to said plane (P), comprising a third active layer (31), at least a part of the third active layer (31) extending opposite another part (1222) of the side surface of the second upper electrode (122), the third active layer (31) being in electrical contact with the second upper electrode (122), the third active layer (31) being a non-volatile resistive memory layer, said third stack comprising a second conductive layer (32) extending on the third active layer (31), at least a part of the conductive layer (32) also extending opposite the other part (1222) of the side surface of the second upper electrode (122);
- the second and third active layers (21, 31) being disjoint, with no direct electrical contact therebetween.

2. The assembly (1) according to the preceding claim,

- comprising a lower electrode (13), which extends beneath the first active layer (11), in parallel thereto, and which is in electrical contact with a lower face (115) of the first active layer (11), wherein
- at least a part of the first upper electrode (121) is located in vertical alignment with the lower electrode (13), superimposed on the lower electrode (13), in a projection along a direction perpendicular to said plane (P), and wherein
- at least a part of the second upper electrode (122) is located in vertical alignment with the lower electrode (13), superimposed on the lower electrode (13), in a projection along a direction perpendicular to said plane (P).

3. The assembly (1) according to the preceding claim, wherein at least one of the upper electrodes (121, 122) is only partially superimposed on the lower electrode (13).

4. The assembly (1) according to claim 2 or 3, wherein:

- the first and second upper electrodes (121, 122) are separated from each other, along a given horizontal direction (X), by a given spacing (D1), and wherein
- along said direction (X), the first upper electrode (121) is superimposed on the lower electrode (13) over a distance which is less than said spacing (D1).

5. The assembly (1) according to one of claims 2 to 4, wherein the first active layer (11) laterally extends beyond the lower electrode (13), protruding on a dielectric layer (61) which surrounds the lower electrode (13).

6. The assembly (1) according to one of the preceding claims, wherein:

- the first active layer (11) is laterally delimited by a side surface (1111, 1122), and
- the assembly (1) further comprises an electrically insulating spacer (151) which extends at least against the side surface (1111, 1122) of the first active layer (11), at least partly covering this side surface (1111, 1122).

7. The assembly (1) according to the preceding claim, wherein the spacer (151) also covers, only partly, the side surface (1211, 1222) of at least one of the first and second upper electrodes (121, 122).

8. The assembly (1) according to one of the preceding claims, wherein the first and second upper electrodes (121, 122) are in direct contact with the first active layer (11).

9. The assembly (1) according to one of the preceding claims, wherein the first planar stack (10) comprises an insulating layer (14) which extends above the first and second upper electrodes (121, 122).

10. The assembly (1) according to the preceding claim, comprising a fourth, planar, stack (10') disposed on the insulating layer (14), the fourth stack comprising:

- a fourth active layer (16) which extends in parallel to said plane (P), the fourth active layer (16) being a selective layer;
- a third and a fourth electrode (171, 172) which extend in parallel to said plane (P), between the fourth active layer (16) and the insulating layer (14), and which are electrically insulated from each other, the third electrode (171) being laterally delimited by a side surface (1711), the fourth electrode (172) being laterally delimited by another side surface (1722), an insulating layer extending between a part of the side surface of the third electrode (171) and a part of the side surface of the fourth electrode (172) to electrically insulate the third electrode from the fourth electrode;
wherein the second active layer (21) extends beyond the side surface (1211) of the first upper electrode (121), extending along a part (1711) of the side surface of the third electrode (171),
and wherein the third active layer (31) extends beyond the side surface (1222) of the second upper electrode (122) by extending along a part (1722) of the side surface of the fourth electrode (172).

11. The assembly (1) according to the preceding claim, wherein the fourth stack comprises:

- a fifth electrode (18), which extends above the fourth active layer (16), in electrical contact with the fourth active layer, and
- an electrically insulating third spacer (152) which covers a side surface (181, 182) of the fifth electrode (18).

12. The assembly (1) according to one of claims 1 to 11, wherein the first active layer (11), common to the second and third stacks (20, 30), is continuous, in one piece.

13. The assembly (1) according to one of claims 1 to 11, wherein the first active layer (11) is divided into a first part (116) and a second part (117), which are disjoint, the first part (116) of the active layer (11) extending beneath the first upper electrode (121), the second part (117) of the active layer (11) extending beneath the second upper electrode (122).

14. A resistive memory array (3) comprising a plurality of assemblies (1) according to one of the preceding claims, wherein, for each assembly (1, 1'):

- the first planar stack (10) of the assembly (1) is electrically connected to an addressing row (81a) of the array,
- the second and third vertical stacks (20, 30) of the assembly (1) are electrically connected to two addressing columns (82a, 82b) of the array respectively, the two addressing columns being distinct.

15. A method for manufacturing an assembly (1) comprising at least two non-volatile resistive memories electrically disposed in parallel with each other and each electrically connected in series to a selective layer forming at least two selectors respectively, each dedicated to one of the memories, the method comprising the following steps of:

- forming a first planar stack (10) comprising:

- depositing a first active layer (11) extending in parallel to a given horizontal plane (P), the first active layer being said selective layer (11); and
- depositing a first upper electrode (121) and a second upper electrode (122) which both extend on the first active layer (11) and which are electrically insulated from each other, the first upper electrode (121) being laterally delimited by a side surface (1211, 1212), the second upper electrode (122) being laterally delimited by another side surface (1221, 1222), an insulating layer (62) extending between a part of the side surface (1212) of the first upper electrode (121) and a part of the side surface (1221) of the second upper electrode (122) to electrically insulate the first upper electrode (121) from the second upper electrode (122);

- forming a second stack (20), which extends obliquely or perpendicularly to said plane (P), comprising a second active layer (21), at least a part of the second active layer (21) extending opposite another part (1211) of the side surface of the first upper electrode (121), the second active layer (21) being in electrical contact with the first upper electrode (121), the second active layer (21) being a non-volatile resistive memory layer, said second stack comprising a first conductive layer (22) extending on the second active layer (21), at least a part of the conductive layer (22) also extending opposite the other part (1211) of the side surface of the first upper electrode (121);
- forming a third stack (30), which extends obliquely or perpendicularly to said plane (P), comprising a third active layer (31), at least a part of the third active layer (31) extending opposite another part (1222) of the side surface of the second upper electrode (122), the third active layer (32) being in electrical contact with the second upper electrode (122), the third active layer (31) being another non-volatile resistive memory layer, said third stack comprising a second conductive layer (32) extending on the third active layer (31), at least a part of the conductive layer (32) also extending opposite the other part (1222) of the side surface of the second upper electrode (122).

16. The method according to the preceding claim, wherein the steps of forming the second and third stacks are performed by carrying out the following steps of:

- conformally depositing an overall active layer (9131), a first part of the overall active layer (9131) extending opposite the side surface (1211) of the first upper electrode (121), the first part of the overall active layer (9131) being in electrical contact with the first upper electrode (121), a second part of the overall active layer (9131) extending opposite the side surface (1222) of the second upper electrode (122), the second part of the overall active layer (9131) being in electrical contact with the second upper electrode (121);
- separating the overall active layer (9131) into at least said second active layer (21) and said one third active layer (31), which are disjoint.

[Fig.1a]

B-B

[Fig.1b]

A-A

[Fig.2]

[Fig.3]

[Fig.4]

[Fig.5]

[Fig.6]

[Fig.7a]

[Fig.7b]

[Fig.8a]

[Fig.8b]

[Fig.9a]

[Fig.9b]

[Fig.10a]

[Fig.10b]

[Fig.11a]

[Fig.11b]

## RÉFÉRENCES CITÉES DANS LA DESCRIPTION

**Documents brevets cités dans la description**

- FR 3100368 A1
- US 2018047787 A1
- US 2014175371 A1